# EUROPÄISCHE PATENTSCHRIFT

(11) **EP 3 657 136 B1**
(45) Veröffentlichungstag und Bekanntmachung des Hinweises auf die Patenterteilung: **21.09.2022**
(21) Anmeldenummer: 19207283.3
(22) Anmeldetag: 05.11.2019
(51) Int. Cl.: G01D 18/00

(54) **VERFAHREN ZUR KALIBRIERUNG EINES PRÜFGEGENSTANDES**
METHOD FOR CALIBRATION OF A TEST SPECIMEN
PROCÉDÉ D'ÉTALONNAGE D'UN OBJET DE VÉRIFICATION

(30) Priorität: 19.11.2018 DE 102018009074
(43) Veröffentlichungstag der Anmeldung: 27.05.2020
(73) Patentinhaber: Esz AG calibration & metrology, 82223 Eichenau (DE)
(72) Erfinder: Fleischmann, Philip M., 82223 Eichenau (DE)
(74) Vertreter: Samson & Partner Patentanwälte mbB

(56) Entgegenhaltungen:
- EP-A1- 1 403 625
- EP-A1- 3 226 002
- DE-A1-102016 112 800

## Beschreibung

### GEBIET DER ERFINDUNG

Die vorliegende Erfindung bezieht sich im Allgemeinen auf das Gebiet der Messtechnik und insbesondere auf ein Verfahren zur Kalibrierung eines Prüfgegenstandes.

### HINTERGRUND DER ERFINDUNG/STAND DER TECHNIK

Herkömmliche Kalibrierverfahren weisen einige Nachteile auf, wie z.B. Fehleranfälligkeiten in Bezug auf die Kalibrierung, die für die Kalibrierung verwendeten Geräte oder fehlende bzw. unzuverlässige Rückführbarkeit.

Die Druckschrift EP 3 226 002 A1 beschreibt ein Verfahren zur Durchführung einer Qualitätskontrolle an einem diagnostischen Analysegerät und umfasst das Empfangen von Kontrollmesswerten von jedem von einer Mehrzahl von diagnostischen Analysatoren. Ein Qualitätskontrollmesswert wird von einem Zieldiagnoseanalysator empfangen. Der Qualitätskontrollmesswert wird mit einem statistischen Kriterium verglichen, das mit der Mehrzahl von Qualitätskontrollmesswerten, die von der Mehrzahl an diagnostischen Analysatoren empfangen wurden assoziiert wird. Ein Vergleichsergebnis wird an eine Benutzerschnittstelle übermittelt, die mit dem Zieldiagnoseanalysator assoziiert ist.

Die Druckschrift US 2008/0312861 A1 beschreibt ein Verfahren zur Kalibrierungsprozessverwaltung einer Kalibrierungstesteinheit und einer Vielzahl von zu testenden Einheiten, umfassend das Konfigurieren einer Benutzerschnittstelle in Kommunikation mit einem Kalibrierungsprozessverwaltungssoftwaresystem und das Konfigurieren einer Kommunikationsverbindung in Kommunikation mit dem Softwaresystem, wobei das Softwaresystem in der Lage ist, mit der Kalibrierungstesteinheit und der Vielzahl von zu testenden Einheiten zu kommunizieren, wobei das Softwaresystem die Benutzerschnittstelle und die Kommunikationsverbindung auf eine Weise verwaltet, die es einem Bediener ermöglicht, die Vielzahl von zu testenden Einheiten zu kalibrieren.

### AUFGABENSTELLUNG

Der vorliegenden Erfindung liegt die Aufgabe zugrunde, ein gegenüber bekannten Ansätzen verbessertes Kalibrierverfahren bereitzustellen.

### KURZBESCHREIBUNG DER ERFINDUNG

Diese Aufgabe wird gelöst durch Gegenstände gemäß der unabhängigen Patentansprüche. Die abhängigen Ansprüche beschreiben bevorzugte Ausführungsformen.

Ein erfindungsgemäßes Verfahren zur Kalibrierung eines Prüfgegenstandes kann die Schritte umfassen:
- Bereitstellen einer Mehrzahl von Kalibriermastern mittels eines Kalibriersystems, wobei ein Kalibriermaster folgendes angibt:
   -- einen zugeordneten Prüfgegenstand,
   -- ein für den zugeordneten Prüfgegenstand vorgesehenes Kalibrierverfahren mit wenigstens einem Kalibrierwert,
   -- eine Messgröße für den zugeordneten Prüfgegenstand,
- Wählen eines Kalibriermasters, dem der Prüfgegenstand zugeordnet ist,
- Definieren von Vorgaben für die Kalibrierung des Prüfgegenstandes, wobei die Vorgaben umfassen:
   -- ein Verfahren zur Lageberechnung von Messwerten der Messgröße bezüglich des jeweiligen Kalibrierwertes und/oder eine Messunsicherheit;
   -- eine dem Kalibrierwert zugeordnete Spezifikation, wobei die Spezifikation bezüglich des Prüfgegenstands festgelegt wird;
- Definieren eines für die angegebene Messgröße geeigneten Prüfmittels; wobei das Verfahren ferner die Schritte umfasst:
- Erzeugen von Messgrößen für jeden Kalibrierwert unter Verwendung des definierten Prüfmittels und
- Übertragen der Messgrößen jeweils von dem Prüfmittel zu dem Prüfgegenstand, wobei der Prüfgegenstand in Antwort auf die übertragenen Messgrößen jeweils Messwerte erzeugt,
- Erfassen der jeweils erzeugten Messwerte mittels des Kalibriersystems,
- jeweiliges Ermitteln der Lage der erfassten Messwerte in Bezug zur festgelegten Spezifikation unter Verwendung des Verfahrens zur Lageberechnung mittels des Kalibriersystems, um zu prüfen, ob der jeweilige Messwert innerhalb der festgelegten Spezifikation liegt, wobei für jeden Messwert die Lageberechnung nach dessen Erfassung durchgeführt wird,
- Durchführen von Konformitätsprüfungen für jeden der erfassten Messwerte,
- Ermitteln mittels des Kalibriersystems auf der Grundlage der durchgeführten Konformitätsprüfungen, ob die Konformitätsbewertung der Kalibrierung des Prüfgegenstandes erfolgreich war oder nicht,
- Durchführen einer Plausibilitätsprüfung mittels des Kalibriersystems, um zu prüfen, ob die Kalibrierung des Prüfgegenstandes nicht-veränderbar freigegeben werden kann oder nicht.

Ein erfindungsgemäßes Verfahren zur Kalibrierung eines Prüfgegenstandes kann die Schritte umfassen:
- Bereitstellen einer Mehrzahl von Kalibriermastern mittels eines Kalibriersystems, wobei ein Kalibriermaster folgendes angibt:
   - einen zugeordneten Prüfgegenstand,
   - ein für den zugeordneten Prüfgegenstand vorgesehenes Kalibrierverfahren mit wenigstens einem Kalibrierwert,
   - eine Messgröße für den zugeordneten Prüfgegenstand,
- Wählen eines Kalibriermasters, dem der Prüfgegenstand zugeordnet ist,
- Definieren von Vorgaben für die Kalibrierung des Prüfmittels, wobei die Vorgaben umfassen:
   -- ein Verfahren zur Lageberechnung von Messwerten der Messgröße bezüglich des jeweiligen Kalibrierwertes und/oder eine Messunsicherheit;
   -- eine dem Kalibrierwert zugeordnete Spezifikation, wobei die Spezifikation bezüglich des Prüfgegenstands festgelegt wird;
- Definieren eines für die angegebene Messgröße geeigneten Prüfmittels;
wobei das Verfahren ferner die Schritte umfasst:
- Erzeugen von Messgrößen für jeden Kalibrierwert unter Verwendung des Prüfgegenstandes und
- Übertragen der Messgrößen jeweils von dem Prüfgegenstand zu dem definierten Prüfmittel, wobei das Prüfmittel in Antwort auf die übertragenen Messgrößen jeweils Messwerte erzeugt,
- Erfassen der jeweils erzeugten Messwerte mittels des Kalibriersystems,
- jeweiliges Ermitteln der Lage der erfassten Messwerte in Bezug zur festgelegten Spezifikation unter Verwendung des Verfahrens zur Lageberechnung mittels des Kalibriersystems, um zu prüfen, ob der jeweilige Messwert innerhalb der festgelegten Spezifikation liegt, wobei für jeden Messwert die Lageberechnung nach dessen Erfassung durchgeführt wird,
- Durchführen von Konformitätsprüfungen für jeden der erfassten Messwerte,
- Ermitteln mittels des Kalibriersystems auf der Grundlage der durchgeführten Konformitätsprüfungen, ob die Konformitätsbewertung der Kalibrierung des Prüfgegenstandes erfolgreich war oder nicht,
- Durchführen einer Plausibilitätsprüfung mittels des Kalibriersystems, um zu prüfen, ob die Kalibrierung des Prüfgegenstandes nicht-veränderbar freigegeben werden kann oder nicht.

Ein erfindungsgemäßes Verfahren kann weiterhin die Schritte gemäß dem Verfahren zur Kalibrierung eines Prüfgegenstandes umfassen, bei dem Messgrößen jeweils von dem Prüfmittel zu dem Prüfgegenstand übertragen werden, wobei der Prüfgegenstand in Antwort auf die übertragenen Messgrößen jeweils Messwerte erzeugt und/oder Schritte gemäß dem Verfahren zur Kalibrierung eines Prüfgegenstandes umfassen, bei dem Messgrößen jeweils von dem Prüfgegenstand zu dem definierten Prüfmittel übertragen werden, wobei das Prüfmittel in Antwort auf die übertragenen Messgrößen jeweils Messwerte erzeugt.

Unter Kalibrieren kann insbesondere ein Messprozess zur zuverlässig reproduzierbaren Feststellung und Dokumentation des Zusammenhangs (z.B. Abweichung) zwischen den Werten eines Prüfgegenstandes (z.B. Anzeige) bzw. eines Messgeräts oder einer Maßverkörperung gegenüber einem anderen (Mess-) Gerät, Normal oder Maßverkörperung verstanden werden. Dabei kann die Einhaltung vorgegebener Toleranzen überprüft und abhängig vom Ergebnis Abgleiche (Justagen) durchgeführt werden.

Üblicherweise wird nach Reparaturen, Wartungsarbeiten, Standortänderungen, Änderung von Umgebungsbedingungen, Benutzung von Mess-, Prüf-, Hilfs- und Arbeitsmitteln, sowie nach Ablauf eines festgesetzten Kalibrierintervalls (Zeitabschnitts) eine Kalibrierung durchgeführt. Eine Erstkalibrierung ist eine erste Kalibrierung eines bisher unbekannten bzw. noch nicht kalibrierten Prüfgegenstandes bzw. Messgerätes oder einer Maßverkörperung.

Unter Kalibrieren kann daher eine Tätigkeit verstanden werden, die unter festgelegten und/oder bekannten Bedingungen/Parametern, welche auch als Einflussgrößen bezeichnet werden können, in einem ersten Schritt eine Beziehung zwischen den durch Normale zur Verfügung gestellten Größenwerten mit ihren Messunsicherheiten und den Anzeigen mit ihren Messunsicherheiten herstellt und in einem zweiten Schritt, Informationen verwendet, um eine Beziehung herzustellen, mit deren Hilfe ein Messergebnis aus einer Anzeige erhalten wird. Die verwendeten Normale können auf nationale Normale rückführbar sein.

Um dauerhaft zuverlässige Messungen zu erreichen, ist es erforderlich, wenn die verwendeten und/oder geeigneten Prüfmittel oder Normale in regelmäßigen Abständen kalibriert werden. Dies gewährleistet unter anderem auch die Rückführung von Prüfmitteln oder Normalen. Diese Abstände werden als Kalibrierintervall bezeichnet. Die Länge des Zeitraumes kann beispielsweise abhängig von den Angaben des Herstellers, den geforderten Messunsicherheiten sowie gesonderte qualitätsspezifische Festlegungen sein. Beispielsweise kann eine Anforderung sein, dass ein vorgegebener Zeitraum seit einer letzten Kalibrierung nicht überschritten sein darf.

Ein Kalibrierwert oder auch Sollwert ist ein Wert, der durch ein Normal, ein Prüfmittel bzw. ein festgelegtes Verfahren erzeugt und/oder bereitgestellt bzw. eingestellt werden kann und entsprechend mit einem Prüfgegenstand und/oder (Mess-) Gerät gemessen wird. Ein Kalibrierwert ist jedoch auch ein Wert, der durch einen Prüfgegenstand bzw. ein (Mess-) Gerät erzeugt und/oder bereitgestellt bzw. eingestellt werden kann und entsprechend mit einem Prüfmittel gemessen wird. Bei der Kalibrierung von Prüfgegenständen, die selbst ebenfalls Größen abgeben, kann der Kalibrierwert, z.B. am Prüfgegenstand, eingestellt werden und ein Messwert, z.B. vom Prüfmittel, gemessen werden. Die bereitgestellten und/oder erzeugten bzw. eingestellten Messgrößen unterliegen einer Messunsicherheit.

Messwert oder auch Istwert ist der vom Prüfgegenstand angezeigte bzw. erzeugte/bereitgestellte Wert einer Messgröße. Der Messwert unterscheidet sich meist bedingt durch die Messabweichung vom Kalibrierwert. Abhängig von dem gewählten Kalibrierverfahren kann der Messwert auch der vom Prüfmittel angezeigte bzw. erzeugte/bereitgestellte Wert einer Messgröße sein. Mehrfachmesswerte können ebenfalls erfasst werden, beispielsweise wenn ein Prüfgegenstand in der Angabe/Anzeige/Ausgabe signifikant schwankt.

Mit anderen Worten, die Zuordnung des Kalibrierwerts bzw. Messwerts kann von dem Kalibrierverfahren abhängen, insbesondere davon, ob die Messgrößen von dem Prüfmittel zu dem Prüfgegenstand erzeugt und übertragen werden oder umgekehrt.

Messunsicherheit ist ein Wertebereich, innerhalb dessen der (wahre) Wert einer Größe mit einer gewissen Wahrscheinlichkeit liegt. Die Messunsicherheit kann beispielsweise ein Wert für einen Bereich sein, in dem der Kalibrierwert einer gemessenen Größe liegt. Messunsicherheiten können statistisch berechnet werden und stehen in Zusammenhang mit der Varianz der gemessenen Werte einer Messreihe. Abhängig vom geforderten Vertrauensniveau kann sich die Messunsicherheit beispielsweise als Vielfaches der Standardabweichung ergeben.

Festgelegte und/oder bekannte Bedingungen/Parameter für die Kalibrierung können Angaben/Informationen über den Standort und die Umgebung umfassen, in der kalibriert wird, wie beispielsweise Temperatur, Druck, Feuchtigkeit, lokale Fallbeschleunigung, Kalibrierstandort, Messwertstreuung, Benutzer und benutzerabhängige Informationen, Kalibriernormale, Ablesefehler oder andere Parameter die auf den Kalibrierprozess Einfluss nehmen. Die erfindungsgemäßen Kalibrierverfahren berücksichtigen stets alle Größen, die den Kalibrierprozess beeinflussen (Einflussgrößen).

Vorteilhaft ist es zum Beispiel, wenn die Kalibrierumgebung, d.h. der Ort an dem der Prüfgegenstand kalibriert wird, wie beispielsweise der Arbeitsplatz, das Labor oder ein Messraum, bei konstanten Bedingungen gehalten wird. Beispielsweise kann die Raumtemperatur bei konstanter Temperatur von 23° C oder 20°C, aber auch bei einem anderen Wert gehalten werden, um Einflüsse von Temperaturschwankungen auf die verwendeten Geräte bzw. die Messergebnisse auszuschließen. Zusätzlich oder alternativ können beispielsweise auch Helligkeit, Luftfeuchte, Druck, Teilchen in der Luft (Reinraum), Gaszusammensetzung und/oder andere Bedingungen konstant gehalten werden. Aktuelle Bedingungen/Parameter werden beim Kalibrieren eines Prüfgegenstandes stets berücksichtigt und gehen in die Messunsicherheit ein.

Unter einem Kalibriermaster kann eine frei konfigurierbare Vorlage für die Kalibrierung eines Prüfgegenstandes verstanden werden. Ein Kalibriermaster kann auch einen Auftragsbezug, wie beispielsweise einen Kundenbezug oder Gerätebezug, aufweisen. Kalibriermaster können jederzeit (neu) angelegt und (erneut) verwendet werden. Ebenso können neue Versionen eines bestehenden Kalibriermasters angelegt werden. Parallel dazu kann die Kalibrierung durchgeführt werden.

Ein Prüfmittel ist ein Messgerät, Referenzmaterial und/oder eine Maßverkörperung oder eine Vorrichtung, die als ein Normal zur Kalibrierung z.B. eines Prüfgegenstandes, (Mess-) Geräts, Referenzmaterials oder einer Maßverkörperung verwendet werden kann. Bei dem erfindungsgemäßen Verfahren zur Kalibrierung eines Prüfgegenstandes können die Prüfmittel jederzeit ausgetauscht, d.h. durch andere geeignete Prüfmittel ersetzt werden. Die Prüfmittel werden stets kontrolliert und deren Brauchbarkeit durch regelmäßige Kalibrierungen im Vergleich mit Nutzerspezifikationen bewertet. Die Prüfmittel sind ebenfalls kalibriert und in der Regel genauer als der zu kalibrierende Prüfgegenstand. Deren Kalibrierparameter sind dokumentiert. Unter dem Begriff "genauer" kann verstanden werden, dass die Prüfmittel beispielsweise eine kleinerer Messunsicherheit aufweisen, als die zu überprüfende Spezifikation. Dies ist allerdings keine zwingende Voraussetzung für ein Prüfmittel.

Die Prüfgegenstände bei dem erfindungsgemäßen Kalibrierverfahren können beispielsweise Messgeräte, Referenzmaterialien oder Geräte zur Bestimmung geometrischer und/oder physikalischer (Mess-) Größen umfassen. Eine Messgröße ist diejenige physikalische Größe, der eine Messung gilt. Bei den zu kalibrierenden Prüfgegenständen kann es sich auch um eine Maßverkörperung handeln.

Diese Prüfgegenstände umfassen beispielsweise Geräte zur Messung von (mechanischen und geometrischen) Messgrößen wie z.B. Zeit, Länge, Fläche, Volumen, Masse, Kraft, Dichte, Temperatur, Brechungsindex, Stoffkonzentrationen; beispielsweise elektrische/elektronische Geräte zur Messung von elektrischen Messgrößen wie z.B. Spannungen, Stromstärken, elektrische Feldstärken, elektrische Leistung/Arbeit, Widerstände, Leitfähigkeiten, Frequenzen; Geräte zur Messung von Magnetischen Messgrößen wie Magnetpole (Kompass), Magnetfeldstärken, magnetischer Fluss, magnetische Aktivität oder beispielsweise Geräte zur Messung von Radioaktivität, Strahlung und optischen Messgrößen, wie z.B. Absorption, Reflexion oder Emission von Spektren oder Wellenlängen, Strahlendosis, Einfall ionisierender Teilchen (radioaktive Strahlung, Röntgenstrahlung), oder Geräte zur Messung anderer Strahlung wie Alpha-, Beta-, Gamma-, oder Neutronenstrahlung oder Strahlungsdurchgang.

Ferner sind auch Prüfgegenstände und/oder Messgeräte umfasst, wie beispielsweise Geräte zur Messung von Geschwindigkeit, Drehzahl, Beschleunigung sowie Kombinationen der Geräte zur Bestimmung geometrischer und/oder physikalischer Messgrößen. Prüfstände beispielsweise von Produktionsstätten im Flug-/Fahrzeug-/Maschinenbau-/Fertigungsbereich, zur Messung von Fahrdynamik wie z.B. Scheinwerfereinstellprüfgeräte, Bremsprüfstände, Aerodynamik, (Aero)-Akustik, Aero-(Elastik), Schall, Licht, und Komfort oder ähnliche Prüfstände sind ebenfalls umfasst.

Die Prüfgegenstände bei dem erfindungsgemäßen Kalibrierverfahren können beispielsweise auch Maßverkörperungen, Stoffe, Stoffgemische, Materialien, Zusammensetzungen jeglicher Art oder beispielsweise auch Gase oder Flüssigkeiten sein.

Anzumerken ist, das Prüfgegenstand bzw. (Mess-) Gerät und Prüfmittel bzw. Normal auch die gleichen Geräte sein können, beispielsweise zwei Gleichspannungsmessgeräte. In anderen Ausführungen unterscheiden sich die Geräte jedoch. "gleich" bedeutet in diesem Zusammenhang, dass die Geräte den gleichen Aufbau, z.B. zwei Gelichspannungsmessgeräte, haben können, das Prüfmittel jedoch genauer sein kann bzw. sein muss, um eine Aussage zu erhalten.

Die Hilfsmittel können bei dem Kalibrierverfahren beispielsweise Kabel, Stromversorgungen, Adapter, Lastwiderstände, Bandmaße, Geräte zur Erfassung der Umgebungs- oder Kalibrierbedingungen, Komparatoren, Anzeigegeräte, Transfernormale Verbindungselemente oder ähnliches sein. Hilfsmittel können beispielsweise verwendet werden um Informationen, Parameter, (Mess-) Größen und Werte zwischen dem Prüfmittel und dem Prüfgegenstand zu übertragen und auszutauschen. Die Hilfsmittel sind als eigenständige Geräte definiert, müssen jedoch nicht zwangsweise bei dem Kalibrierverfahren verwendet werden. Vielmehr richtet sich die Anzahl sowie die Art der zu verwendenden Hilfsmittel nach dem zu kalibrierenden Prüfgegenstand. Eine Verbindung kann daher beispielsweise auch Kabellos sein, sodass unter Umständen auch kein Hilfsmittel erforderlich sein kann. Werden hingegen Hilfsmittel bei der Kalibrierung verwendet, werden diese auch bei der Kalibrierung berücksichtigt.

Die Vorgaben für die Kalibrierung können eine Auswahl an (geeigneten) Prüfmitteln umfassen, wobei ein Prüfmittel austauschbar sein kann, d.h. ein Prüfmittel kann jederzeit durch ein anderes (geeignetes) Prüfmittel für eine Kalibrierung ersetzt werden. Definieren eines für die angegebene Messgröße geeigneten Prüfmittels kann insbesondere Anlegen eines (neuen) Prüfmittels bedeuten, welches in den Vorgaben bzw. der Auswahl an Prüfmitteln zuvor noch nicht vorhanden war oder Auswählen bzw. Festlegen eines in der Auswahl bzw. den Vorgaben bereits vorhandenen oder kürzlich neu angelegten Prüfmittels bedeuten. Insbesondere kann der Kalibriermaster einen Vorschlag für ein geeignetes Prüfmittel bereitstellen oder, für den Fall, dass kein geeignetes Prüfmittel angelegt bzw. vorhanden ist, auffordern ein (neues) Prüfmittel anzulegen.

Alle mehrere oder einzelne Vorgaben sowie Angaben in dem Kalibriermaster, bzw. auch der Kalibriermaster selbst, können für die Kalibrierung ebenfalls spezifisch, veränderbar und anpassbar sein. Insbesondere ist ein Nullwert ebenfalls umfasst. Ein Nullwert kann beispielsweise als Spezifikation in den Vorgaben für die Kalibrierung immer dann eingetragen sein bzw. eingegeben werden, wenn keine Spezifikation benötigt oder angefordert wird. In einem solchen Fall wird ein Prüfgegenstand also ohne diese zugehörige Spezifikation kalibriert.

Die Vorgaben können sich also, beispielsweise von Kalibrierung zu Kalibrierung und abhängig von speziellen, definierten Anforderungen unterscheiden oder aber auch gleich sein. Sollte ein geeigneter Kalibriermaster nicht vorhanden sein, kann ein neuer Kalibriermaster jederzeit (beispielsweise mit Auftragsbezug) angelegt werden.

Eine Spezifikation ist die Vorgabe eines Gerätes und/oder eines Anwenders (z.B. die Vorgabe von Toleranzgrenzen bzw. des Toleranzbereiches oder -feldes). Zur Kalibrierung eines Prüfgegenstandes kann eine Spezifikation auch einen Nullwert umfassen. Insbesondere kann eine Spezifikation kundenspezifisch sein. In diesem Fall wird der Prüfgegenstand ohne Angabe einer Spezifikation kalibriert, beispielsweise wenn lediglich eine allgemeinere Aussage über die Funktion des Prüfgegenstands erhalten werden soll, bzw. der zu kalibrierende Prüfgegenstand nicht in Bezug auf eine Spezifikation kalibriert werden soll. Für die Kalibrierung mit einem Nullwert in der Spezifikation ist ein Dokument notwendig, dass den Grund für eine derartige Kalibrierung angibt. Wird ein Nullwert als Spezifikation gewählt, kann eine Aussage zur Konformitätsbewertung entfallen.

Bei einem, mehreren oder allen der erfindungsgemäßen Verfahren zur Kalibrierung eines Prüfgegenstandes kann eine Ergebnisbericht und/oder ein Kalibrierschein erstellt werden, sowie, beispielsweise optional, eine Kennzeichnung des Prüfgegenstandes. Eine Kennzeichnung kann z.B. ein Kalibriersiegel sein, welches beispielsweise angibt, dass der Prüfgegenstand (z.B. erfolgreich) kalibriert ist.

Ein Kalibrierschein dokumentiert die erfolgte Kalibrierung eines Prüfmittels oder Prüfgegenstandes. Dazu können Gerätedaten des Prüfmittels oder des Prüfgegenstandes sowie die während der Kalibrierung gemessenen Messwerte erfasst werden. Beispielsweise kann der Inhalt des Kalibrierscheins angeben, welches Labor die Messungen durchgeführt hat, wo und unter welchen Bedingungen die Kalibrierung durchgeführt wurde, welche Prüfmittel dazu verwendet wurden, welches Verfahren eingesetzt wurde, welche Abweichungen und Messunsicherheiten ermittelt wurden und welche Spezifikationen (wenn festgelegt) erfüllt bzw. eingehalten wurden. Der Kalibrierschein kann automatisch in einer oder mehreren Sprachen, d.h. "auf Knopfdruck" ausgegeben bzw. generiert werden. Ein Kalibrierschein dient unter anderem der Qualitätssicherung.

Ein Kalibriersiegel kennzeichnet ein Gerät als kalibriert und kann eine eindeutige Nummer tragen, um die Zuordnung zu einem zugehörigen Kalibrierschein mit den ermittelten Messwerten zu ermöglichen. Zudem kann das Kalibriersiegel ein Datum der Kalibrierung sowie einen Code, um das Kalibriersiegel jederzeit abrufen zu können, z.B. online, und/oder einen Zeitpunkt der nächsten Kalibrierung umfassen.

Weiterhin kann eines, mehrere oder alle der erfindungsgemäßen Verfahren zur Kalibrierung eines Prüfgegenstandes einen Ergebnisbericht (d.h. den Kalibrierschein) sowie die Kennzeichnung des Prüfgegenstandes ausgeben. Ebenfalls kann eine Freigabe der Kalibrierung und des Ergebnisberichtes (d.h. des Kalibrierscheins) durchgeführt werden, um diese beispielsweise nicht-veränderbar zu speichern.

Unter Konformitätsprüfungen kann die Prüfung der Konformität für jeden Messwert beispielsweise direkt im Anschluss an die Aufnahme/Erfassung des Messwertes und dessen Lageberechnung verstanden werden. Konformitätsprüfungen können also für jeden Messwert einzeln und direkt nach dessen Erfassung durchgeführt werden. Zusätzlich kann eine Entscheidungsregel für die Konformitätsprüfungen erforderlich sein, beispielsweise, um eine Bewertung der Lage im Toleranzfeld vornehmen zu können. Eine Toleranzauswertung kann sowohl mit als auch ohne Berücksichtigung der Messunsicherheit gesteuert werden.

Eine Konformitätsbewertung kann als Darlegung und/oder Beurteilung verstanden werden, dass festgelegte und/oder vorgegebene Anforderungen bezogen auf ein Produkt, einen Prozess, ein System, eine Person oder eine Stelle erfüllt sind, beispielsweise die Übereinstimmung eines Prüfgegenstandes mit einer geregelten Norm, einer Hersteller-, Anwendungs-, Richtlinien-, Nutzer- und/oder industrieller Vorgabe. Diese können auch als Konformitätsvorgaben bezeichnet werden.

Insbesondere wird beurteilt, ob ein Kalibriergegenstand bzw. ein zu kalibrierender Prüfgegenstand, für alle Messwerte bzw. Kalibrierwerte innerhalb oder außerhalb einer (z.B. festgelegte und/oder definierten) Spezifikation, beispielsweise eines Toleranzbereichs liegt oder nicht. Gemäß dem erfindungsgemäßen Kalibrierverfahren wird für jeden Messschritt und/oder Messwert einer Messgröße einzeln eine Bewertung nach dessen Erfassung vorgenommen und die Abweichung und die Lage im Toleranzfeld ("*%*TOL) an- bzw. ausgegeben (Lageberechnung).

Die Konformität wird dabei bereits während des Kalibriervorgangs und für jeden Messschritt und/oder Messwert einer Messgröße angezeigt. Die Lageberechnung wird für jeden Messwert ebenfalls direkt im Anschluss an die Aufnahme bzw. Erfassung des Messwertes durchgeführt. Dadurch wird die Berechnungsart der Prozentwerte ("*%*TOL) in der Kalibrierung verändert und die Aussage über die Kalibrierung wird dadurch genauer bzw. detaillierter/spezifischer. Eine Bewertung kann auf der Grundlage aller durchgeführten Konformitätsprüfungen durchgeführt werden, beispielsweise, wenn alle Konformitätsprüfungen erfolgreich waren.

Beispielsweise kann eine absolute Abweichung berechnet werden durch "Messwert - Kalibrierwert" und eine relative Abweichung durch "(Messwert - Kalibrierwert)/Kalibrierwert".

Ferner kann die Lage im Toleranzfeld ("*%*TOL") berechnet werden durch "Betrag der absoluten Abweichung/einfaches Toleranzfeld", wobei folgendes festgelegt werden kann:
- 0 *%*TOL: Kalibrierwert entspricht gleich Messwert;
- 100 *%*TOL*:* Toleranzgrenze genau erreicht;
- > 100 *%*TOL: außerhalb der Toleranz.

Die Messunsicherheit kann dabei einen Einfluss auf die Konformitätsbewertung haben. Je kleiner die Messunsicherheit ist, desto "sicherer", d.h. aussagekräftiger wird die Aussage über den Mess-/Kalibrierwert in Bezug auf die Spezifikation (z.B. Vorgabe von Toleranzgrenzen bzw. des Toleranzbereiches oder -feldes). Mit anderen Worten, desto "sicherer" befindet sich die Lage eines Wertes innerhalb oder außerhalb der Toleranzgrenzen bzw. des Toleranzbereiches oder -feldes.

Beispielsweise kann der Mess-/Kalibrierwert über/unterhalb einer (beispielsweise festgelegten und/oder definierten Eingriffsgrenze) Obergrenze liegen. Folgende Fälle können beispielsweise gekennzeichnet und unterschieden werden.:
- sicher innerhalb der Spezifikation;
- unsicher innerhalb der Spezifikation;
- unsicher außerhalb der Spezifikation;
- sicher außerhalb der Spezifikation.

Die Begriffe "sicher" und "unsicher" geben in diesem Zusammenhang eine Wahrscheinlichkeit an. Sicher bedeutet üblicherweise zu beispielsweise 95 *%* innerhalb bzw. außerhalb der Spezifikation. Ein Prozentsatz kleiner als beispielsweise 95 *%* bedeutet demnach nicht "sicher" bzw. unsicher innerhalb bzw. außerhalb der Spezifikation.

Erfolgen Konformitätsbewertungen im Ergebnisbericht (Kalibrierschein), so
- beschränken sich die Aussagen auf die umfassten Messpunkte und nicht auf das Gerät selbst;
- wird die Bewertung ohne oder unter Berücksichtigung der Messunsicherheit durchgeführt und für letzteren Fall als eine unsichere Bewertung gekennzeichnet;
- wird die Quelle der Bewertung (Quelle der Spezifikation), d.h. auf welche Spezifikation sich die Kalibrierung stützt, im Kalibrierschein angegeben, so dass eine Überprüfung der angegebenen/spezifizierten Bedingungen, beispielsweise den Toleranzgrenzen jederzeit möglich ist;
- werden die Toleranzangaben zusammen mit den Ergebnissen auf dem Kalibrierschein genannt.

Plausibilitätsprüfung ist die Überprüfung eines Wertes, dahingehend, ob dieser überhaupt plausibel, annehmbar, stimmig, sinnvoll, einleuchtend oder nachvollziehbar sein kann oder nicht. Plausibilitätsprüfungen sichern z.B. die Qualität der Kalibrierung. In manchen Fällen kann nicht immer die Richtigkeit des Wertes oder Ergebnisses verifiziert werden, sondern es muss eine vorhandene (offensichtliche) Unrichtigkeit des Wertes erkannt werden. Ist diese Prüfung fehlerfrei, ist die Freigabe möglich.

Plausibilitätsprüfungen können zur Freigabe sperrende Meldungen, die eine Freigabe verhindern, warnende Meldungen, die beispielsweise auf ein Ergebnis oder einen Wert aufmerksam machen sollen und informative Meldungen, die lediglich über das Ergebnis informieren, umfassen. Beispiele einer Plausibilitätsprüfung können sein: Übersetzung, Standortbezug, Durchgeführte Arbeiten, Optionen des Kalibriergegenstandes, Messunsicherheiten, Kalibrierzeit, Kalibrierstatus, Prüfmittel, Hilfsmittel, Messwerte, Messreihenkennzeichnung (Eingangswerte, Ausgangswerte), Vollständigkeit der Ergebnisse, Inkonsistenzen der Messreihe, Freigabe, Datum, Kommentare oder viele weitere andere. Bei der Plausibilitätsprüfung wird also unter anderem überprüft, ob die untersuchten Daten gültig sind.

Bei einem, mehreren oder allen Kalibrierverfahren kann ein Driftbericht erzeugt werden, wenn wenigstens zwei Kalibriervorgänge zu einem Messgerät existieren oder vorgenommen worden sind. Der Driftbericht dient zum Vergleichen von ermittelten Messwerten einer Kalibrierung zu der vorangegangenen Kalibrierung über einen (beispielsweise festgelegten) Zeitraum. Für einen Driftbericht müssen wenigstens zwei Kalibriervorgänge existieren. Bei dem Kalibrierverfahren kann auch vorgegeben werden, wie groß die Abweichung des Kalibrierwertes sein darf, wenn Werte von einer Kalibrierung zur nächsten verglichen werden.

Ein Driftbericht kann Werte aus bereits existierenden Kalibrierungen umfassen, sowie Maximaldrift (größter Wert aller Driften der ermittelten Historie), mittlere Drift (Mittelwert aller Driften), welche über alle existierenden Kalibrierungen ermittelt werden und eine Bemerkung. Die Bemerkung kann beispielsweise eine Risikoabschätzung sein und Auskunft darüber geben, wie hoch die Wahrscheinlichkeit ist, dass das Messgerät in der nächsten Folgekalibrierung Werte außerhalb des Toleranzbereichs aufweist oder aufweisen wird. Aussagen über das Driftverhalten des Messgeräts in der Zukunft sind damit ebenfalls möglich.

Ferner können die Vorgaben des erfindungsgemäßen Verfahrens
-- Prüfmittelvorgaben umfassen, welche von dem Prüfmittel bereitgestellt werden, wobei die Prüfmittelvorgaben eine Eignung des Prüfmittels bezüglich des jeweiligen Kalibrierwertes und/oder einer Messunsicherheit und/oder eines Standortes zur Durchführung des Kalibrierverfahrens bereitstellen; sowie
-- eine Auswahl an für die Bereitstellung der angegebenen Messgröße geeigneten Prüfmitteln;
-- eine Entscheidungsregel zur Konformitätsprüfung;
-- ein Verfahren zur Risikobewertung von Messwerten bezüglich der jeweiligen Messunsicherheit.

Ein Verfahren zur Risikobewertung von Messschritten bezüglich einer jeweiligen Messunsicherheit kann das Risiko bei der erfindungsgemäßen Kalibrierung eines

Prüfgegenstandes minimieren. Die Unterschreitung eines, beispielsweise festgelegten, Grenzwertes setzt die individuelle Einschätzung des Risikos einer Fehlentscheidung bzw. fehlerhaften Konformitätsprüfungen (z.B. Falsch-Gut-Bewertungen) sowie einer Freigabe voraus.

Weiterhin kann das Kalibriersystem des erfindungsgemäßen Verfahrens eine Methode zur Messunsicherheitsberechnung bereitstellen. Das erfindungsgemäße Verfahren kann weiter umfassen:
- jeweiliges Ermitteln von Messunsicherheiten für die erfassten Messwerte unter Verwendung des angegebenen Verfahrens zur Messunsicherheitsberechnung mittels des Kalibriersystems,
- jeweiliges Ermitteln eines Risikos für die erfassten Messwerte mittels des Kalibriersystems,
   und
- Bewerten der jeweils ermittelten Messunsicherheiten und/oder des jeweils ermittelten Risikos gemäß gewählter Übereinstimmungskriterien.

Eines, mehrere oder jedes der erfindungsgemäßen Verfahren kann weiter umfassen:
- jeweiliges Ermitteln von Messunsicherheiten für die erfassten Messwerte unter Berücksichtigung von Prüfmittel, Messbereich, und/oder Kalibrierverfahren, und/oder Kalibrierbedingungen und/oder Standort und/oder Standort-/Umgebungsbedingungen und/oder Ablesbarkeit und/oder Mehrfachmessungen und/oder Eigenschaften des Prüfgegenstandes.

Weiterhin kann das Kalibriersystem des erfindungsgemäßen Verfahrens eine Methode zur Berechnung für korrigierte bereitgestellte und/oder korrigierte erfasste Messwerte umfassen.

Eines, mehrere oder jedes der erfindungsgemäßen Verfahren kann weiter umfassen:
- jeweiliges Ermitteln von Korrekturwerten für korrigierte bereitgestellte und/oder korrigierte erfasste Messwerte unter Berücksichtigung von Prüfmittel, Messbereich, und/oder Kalibrierverfahren, und/oder Kalibrierbedingungen und/oder Standort und/oder Standort-/Umgebungsbedingungen und/oder Ablesbarkeit und/oder Mehrfachmessungen und/oder Eigenschaften des Prüfgegenstandes;
- jeweiliges Ermitteln eines Risikos für die erfassten Messwerte mittels des Kalibriersystems,
- Bewerten der korrigierten bereitgestellten und/oder korrigierten erfassten Messwerte und/oder des jeweils ermittelten Risikos gemäß gewählter Übereinstimmungskriterien.

Bei dem erfindungsgemäßen Verfahren kann
- wenigstens eine frühere Kalibrierung des zugeordneten Prüfgegenstandes vorliegen, und
- bei Verwendung einer solchen früheren Kalibrierung durch Vergleich mit einer aktuellen Kalibrierung des zugeordneten Prüfgegenstandes ein Driftbericht erstellt werden.

Bei dem erfindungsgemäßen Verfahren kann für jeden Messwert eine Lageberechnung, Risikoermittlung, Risikobewertung und Konformitätsprüfung nach dessen Erfassung durchgeführt werden, bevor ein weiterer Messwert erfasst wird.

Bei dem erfindungsgemäßen Verfahren kann
- das Kalibriersystem ferner folgendes angeben:
   -- wenigstens ein Hilfsmittel zur Durchführung des Kalibrierverfahrens,
   -- wenigstens eine Umgebungsbedingung für die Durchführung des Kalibrierverfahrens,
   -- einen Standort zur Durchführung des Kalibrierverfahrens,
   -- wenigstens eine Messunsicherheit,
   -- wenigstens ein für die Bereitstellung der angegebenen Messgröße geeigneten Prüfmittel,
   -- Vollständigkeit von Übersetzungen,
   -- Befugnisse der für die Durchführung der Freigabe verantwortlichen Personen,
   -- Veränderungen der Messreihe bei Vorliegen eines noch nicht freigegebenen Ergebnisberichtes,
   -- Vollständigkeit von Vorgaben aus dem Kalibriermaster,
   -- Bewertung gemäß gewählter Übereinstimmungskriterien,
   wobei
   die Konformitätsprüfung und/oder die Plausibilitätsprüfung und/oder die Konformitätsbewertung unter Berücksichtigung wenigstens einer der obigen Angaben durchgeführt werden.

Weiterhin ist ein erfindungsgemäßes Computerprogrammprodukt beschrieben, umfassend Befehle, die bei der Ausführung des Programms durch einen Computer diesen veranlassen, die Schritte eines, mehrerer oder jedes erfindungsgemäßen Verfahrens zur Kalibrierung eines Prüfgegenstandes auszuführen.

Ferner ist ein erfindungsgemäßes System zur Kalibrierung eines Prüfgegenstandes beschrieben, dass
- ein Prüfmittel und
- ein Kalibriersystem umfasst,
wobei mittels des Kalibriersystems:
- eine Mehrzahl von Kalibriermastern bereitstellt werden, wobei ein Kalibriermaster folgendes angibt:
   -- einen zugeordneten Prüfgegenstand,
   -- ein für den zugeordneten Prüfgegenstand vorgesehenes Kalibrierverfahren mit wenigstens einem Kalibrierwert,
   -- eine Messgröße für den zugeordneten Prüfgegenstand,
- ein Kalibriermaster gewählt wird, dem der Prüfgegenstand zugeordnet ist,
- Vorgaben für die Kalibrierung des Prüfgegenstandes gewählt werden, wobei die Vorgaben umfassen:
   - ein Verfahren zur Lageberechnung von Messwerten der Messgröße bezüglich des jeweiligen Kalibrierwertes und/oder eine Messunsicherheit;
   - eine dem Kalibrierwert zugeordnete Spezifikation, wobei die Spezifikation bezüglich des Prüfgegenstands festgelegt wird;
- ein für die angegebene Messgröße geeignetes Prüfmittel definiert wird;
   wobei das definierte Prüfmittel
   Messgrößen für jeden Kalibrierwert erzeugt und
   die Messgrößen jeweils von dem Prüfmittel zu dem Prüfgegenstand übertragen werden, wobei der Prüfgegenstand in Antwort auf die übertragenen Messgrößen jeweils Messwerte erzeugt,
- die jeweils erzeugten Messwerte erfasst werden,
- die Lage der erfassten Messwerte in Bezug zur festgelegten Spezifikation unter Verwendung des Verfahrens zur Lageberechnung jeweils ermittelt wird, um zu prüfen, ob der jeweilige Messwert innerhalb der festgelegten Spezifikation liegt, wobei für jeden Messwert die Lageberechnung nach dessen Erfassung durchgeführt wird,
- Konformitätsprüfungen für jeden der erfassten Messwerte durchgeführt werden,
- auf der Grundlage der durchgeführten Konformitätsprüfungen ermittelt wird, ob die Konformitätsbewertung der Kalibrierung des Prüfgegenstandes erfolgreich war oder nicht,
- eine Plausibilitätsprüfung durchgeführt wird, um zu prüfen, ob die Kalibrierung des Prüfgegenstandes nicht-veränderbar freigegeben werden kann oder nicht.

Ferner ist ein erfindungsgemäßes System zur Kalibrierung eines Prüfgegenstandes beschrieben, dass
- ein Prüfmittel und
- ein Kalibriersystem umfasst,
wobei mittels des Kalibriersystems:
- eine Mehrzahl von Kalibriermastern bereitstellt werden, wobei ein Kalibriermaster folgendes angibt:
   -- einen zugeordneten Prüfgegenstand,
   -- ein für den zugeordneten Prüfgegenstand vorgesehenes Kalibrierverfahren mit wenigstens einem Kalibrierwert,
   -- eine Messgröße für den zugeordneten Prüfgegenstand,
- ein Kalibriermaster gewählt wird, dem der Prüfgegenstand zugeordnet ist,
- Vorgaben für die Kalibrierung des Prüfgegenstandes gewählt werden, wobei die Vorgaben umfassen:
   -- ein Verfahren zur Lageberechnung von Messwerten der Messgröße bezüglich des jeweiligen Kalibrierwertes und/oder eine Messunsicherheit;
   -- eine dem Kalibrierwert zugeordnete Spezifikation, wobei die Spezifikation bezüglich des Prüfgegenstands festgelegt wird;
- ein für die angegebene Messgröße geeignetes Prüfmittel definiert wird;
   wobei der Prüfgegenstand
   Messgrößen für jeden Kalibrierwert erzeugt und
   die Messgrößen jeweils von dem Prüfgegenstand zu dem definierten Prüfmittel übertragen werden, wobei das Prüfmittel in Antwort auf die übertragenen Messgrößen jeweils Messwerte erzeugt,
- die jeweils erzeugten Messwerte erfasst werden,
- die Lage der erfassten Messwerte in Bezug zur festgelegten Spezifikation unter Verwendung des Verfahrens zur Lageberechnung jeweils ermittelt wird, um zu prüfen, ob der jeweilige Messwert innerhalb der festgelegten Spezifikation liegt, wobei für jeden Messwert die Lageberechnung nach dessen Erfassung durchgeführt wird,
- Konformitätsprüfungen für jeden der erfassten Messwerte durchgeführt werden,
- auf der Grundlage der durchgeführten Konformitätsprüfungen ermittelt wird, ob die Konformitätsbewertung der Kalibrierung des Prüfgegenstandes erfolgreich war oder nicht,
- eine Plausibilitätsprüfung durchgeführt wird, um zu prüfen, ob die Kalibrierung des Prüfgegenstandes nicht-veränderbar freigegeben werden kann oder nicht.

Ein erfindungsgemäßes System kann weiterhin zur Kalibrierung eines Prüfgegenstandes ein Kalibriersystem und ein Prüfmittel umfassen, bei dem Messgrößen jeweils von dem Prüfmittel zu dem Prüfgegenstand übertragen werden, wobei der Prüfgegenstand in Antwort auf die übertragenen Messgrößen jeweils Messwerte erzeugt und/oder ein Kalibriersystem und ein Prüfmittel umfassen, bei dem Messgrößen jeweils von dem Prüfgegenstand zu dem definierten Prüfmittel übertragen werden, wobei das Prüfmittel in Antwort auf die übertragenen Messgrößen jeweils Messwerte erzeugt.

Ferner können die Vorgaben der erfindungsgemäßen Systeme
-- Prüfmittelvorgaben umfassen, welche von dem Prüfmittel bereitgestellt werden, wobei die Prüfmittelvorgaben eine Eignung des Prüfmittels bezüglich des jeweiligen Kalibrierwertes und/oder einer Messunsicherheit und/oder eines Standortes zur Durchführung des Kalibrierverfahrens bereitstellen; sowie
-- eine Auswahl an für die Bereitstellung der angegebenen Messgröße geeigneten Prüfmitteln;
-- eine Entscheidungsregel zur Konformitätsprüfung;
-- ein Verfahren zur Risikobewertung von Messwerten bezüglich der jeweiligen Messunsicherheit.

Weiterhin kann das Kalibriersystem der erfindungsgemäßen Systeme eine Methode zur Messunsicherheitsberechnung bereitstellen, wobei mittels des Kalibriersystems
- Messunsicherheiten für die erfassten Messwerte unter Verwendung des angegebenen Verfahrens zur Messunsicherheitsberechnung jeweils ermittelt werden,
- ein Risiko für die erfassten Messwerte jeweils ermittelt wird,
   und
- die jeweils ermittelten Messunsicherheiten und/oder des jeweils ermittelten Risikos gemäß gewählter Übereinstimmungskriterien bewertet werden.

Bei den erfindungsgemäßen Systemen können mittels des Kalibriersystems
- Messunsicherheiten für die erfassten Messwerte unter Berücksichtigung von Prüfmittel, Messbereich, und/oder Kalibrierverfahren, und/oder Kalibrierbedingungen und/oder Standort und/oder Standort-/Umgebungsbedingungen und/oder Ablesbarkeit und/oder Mehrfachmessungen und/oder Eigenschaften des Prüfgegenstandes jeweils ermittelt werden.

Weiterhin kann das Kalibriersystem bei den erfindungsgemäßen Systemen eine Methode zur Berechnung für korrigierte bereitgestellte und/oder korrigierte erfasste Messwerte umfassen.

Die erfindungsgemäßen Systeme können, mittles des Kalibriersystems
- Korrekturwerte für korrigierte bereitgestellte und/oder korrigierte erfasste Messwerte unter Berücksichtigung von Prüfmittel, Messbereich, und/oder Kalibrierverfahren, und/oder Kalibrierbedingungen und/oder Standort und/oder Standort-/Umgebungsbedingungen und/oder Ablesbarkeit und/oder Mehrfachmessungen und/oder Eigenschaften des Prüfgegenstandes jeweils ermitteln;
- ein Risiko für die erfassten Messwerte jeweils ermitteln,
- die korrigierten bereitgestellten und/oder korrigierten erfassten Messwerte und/oder das jeweils ermittelte Risiko gemäß gewählter Übereinstimmungskriterien bewerten.

Bei den erfindungsgemäßen Systemen kann, dem Kalibriersystem
- wenigstens eine frühere Kalibrierung des zugeordneten Prüfgegenstandes vorliegen, und
- bei Verwendung einer solchen früheren Kalibrierung durch Vergleich mit einer aktuellen Kalibrierung des zugeordneten Prüfgegenstandes ein Driftbericht erstellt werden.

Bei den erfindungsgemäßen Systemen kann das Kalibriersystem für jeden Messwert eine Lageberechnung, Risikoermittlung, Risikobewertung und Konformitätsprüfung nach dessen Erfassung durchführen, bevor ein weiterer Messwert erfasst wird.

Bei den erfindungsgemäßen Systemen kann
- das Kalibriersystem ferner folgendes angeben:
   -- wenigstens ein Hilfsmittel zur Durchführung des Kalibrierverfahrens,
   -- wenigstens eine Umgebungsbedingung für die Durchführung des Kalibrierverfahrens,
   -- einen Standort zur Durchführung des Kalibrierverfahrens,
   -- wenigstens eine Messunsicherheit,
   -- wenigstens ein für die Bereitstellung der angegebenen Messgröße geeigneten Prüfmittel,
   -- Vollständigkeit von Übersetzungen,
   -- Befugnisse der für die Durchführung der Freigabe verantwortlichen Personen,
   -- Veränderungen der Messreihe bei Vorliegen eines noch nicht freigegebenen Ergebnisberichtes,
   -- Vollständigkeit von Vorgaben aus dem Kalibriermaster,
   -- Bewertung gemäß gewählter Übereinstimmungskriterien,
   wobei
   die Konformitätsprüfung und/oder die Plausibilitätsprüfung und/oder die Konformitätsbewertung unter Berücksichtigung wenigstens einer der obigen Angaben durchgeführt werden.

Ferner ist ein erfindungsgemäßes Prüfmittel zur Verwendung mit einem erfindungsgemäßem Kalibriersystem zur Kalibrierung eines Prüfgegenstandes beschrieben,
wobei mittels des Kalibriersystems:
- eine Mehrzahl von Kalibriermastern bereitstellt werden, wobei ein Kalibriermaster folgendes angibt:
   -- einen zugeordneten Prüfgegenstand,
   -- ein für den zugeordneten Prüfgegenstand vorgesehenes Kalibrierverfahren mit wenigstens einem Kalibrierwert,
   -- eine Messgröße für den zugeordneten Prüfgegenstand,
- ein Kalibriermaster gewählt wird, dem der Prüfgegenstand zugeordnet ist,
- Vorgaben für die Kalibrierung des Prüfgegenstandes gewählt werden, wobei die Vorgaben umfassen:
   -- ein Verfahren zur Lageberechnung von Messwerten der Messgröße bezüglich des jeweiligen Kalibrierwertes und/oder eine Messunsicherheit;
   -- eine dem Kalibrierwert zugeordnete Spezifikation, wobei die Spezifikation bezüglich des Prüfgegenstands festgelegt wird;
- ein für die angegebene Messgröße geeignetes Prüfmittel definiert wird;
   wobei das definierte Prüfmittel
   Messgrößen für jeden Kalibrierwert erzeugt und
   die Messgrößen jeweils von dem Prüfmittel zu dem Prüfgegenstand übertragen werden, wobei der Prüfgegenstand in Antwort auf die übertragenen Messgrößen jeweils Messwerte erzeugt,
- die jeweils erzeugten Messwerte erfasst werden,
- die Lage der erfassten Messwerte in Bezug zur festgelegten Spezifikation unter Verwendung des Verfahrens zur Lageberechnung jeweils ermittelt wird, um zu prüfen, ob der jeweilige Messwert innerhalb der festgelegten Spezifikation liegt, wobei für jeden Messwert die Lageberechnung nach dessen Erfassung durchgeführt wird,
- Konformitätsprüfungen für jeden der erfassten Messwerte durchgeführt werden,
- auf der Grundlage der durchgeführten Konformitätsprüfungen ermittelt wird, ob die Konformitätsbewertung der Kalibrierung des Prüfgegenstandes erfolgreich war oder nicht,
- eine Plausibilitätsprüfung durchgeführt wird, um zu prüfen, ob die Kalibrierung des Prüfgegenstandes nicht-veränderbar freigegeben werden kann oder nicht.

Ferner ist ein erfindungsgemäßes Prüfmittel zur Verwendung mit einem erfindungsgemäßem Kalibriersystem zur Kalibrierung eines Prüfgegenstandes beschrieben, wobei wobei mittels des Kalibriersystems:
- eine Mehrzahl von Kalibriermastern bereitstellt werden, wobei ein Kalibriermaster folgendes angibt:
   -- einen zugeordneten Prüfgegenstand,
   -- ein für den zugeordneten Prüfgegenstand vorgesehenes Kalibrierverfahren mit wenigstens einem Kalibrierwert,
   -- eine Messgröße für den zugeordneten Prüfgegenstand,
- ein Kalibriermaster gewählt wird, dem der Prüfgegenstand zugeordnet ist,
- Vorgaben für die Kalibrierung des Prüfgegenstandes gewählt werden, wobei die Vorgaben umfassen:
   -- ein Verfahren zur Lageberechnung von Messwerten der Messgröße bezüglich des jeweiligen Kalibrierwertes und/oder eine Messunsicherheit;
   -- eine dem Kalibrierwert zugeordnete Spezifikation, wobei die Spezifikation bezüglich des Prüfgegenstands festgelegt wird;
- ein für die angegebene Messgröße geeignetes Prüfmittel definiert wird;
   wobei der Prüfgegenstand
   Messgrößen für jeden Kalibrierwert erzeugt und
   die Messgrößen jeweils von dem Prüfgegenstand zu dem definierten Prüfmittel übertragen werden, wobei das Prüfmittel in Antwort auf die übertragenen Messgrößen jeweils Messwerte erzeugt,
- die jeweils erzeugten Messwerte erfasst werden,
- die Lage der erfassten Messwerte in Bezug zur festgelegten Spezifikation unter Verwendung des Verfahrens zur Lageberechnung jeweils ermittelt wird, um zu prüfen, ob der jeweilige Messwert innerhalb der festgelegten Spezifikation liegt, wobei für jeden Messwert die Lageberechnung nach dessen Erfassung durchgeführt wird,
- Konformitätsprüfungen für jeden der erfassten Messwerte durchgeführt werden,
- auf der Grundlage der durchgeführten Konformitätsprüfungen ermittelt wird, ob die Konformitätsbewertung der Kalibrierung des Prüfgegenstandes erfolgreich war oder nicht,
- eine Plausibilitätsprüfung durchgeführt wird, um zu prüfen, ob die Kalibrierung des Prüfgegenstandes nicht-veränderbar freigegeben werden kann oder nicht.

Bei dem erfindungsgemäßen Prüfmittel zur Verwendung mit einem erfindungsgemäßem Kalibriersystem kann weiterhin zur Kalibrierung eines Prüfgegenstandes ein Kalibriersystem und ein Prüfmittel umfasst sein, bei dem Messgrößen jeweils von dem Prüfmittel zu dem Prüfgegenstand übertragen werden, wobei der Prüfgegenstand in Antwort auf die übertragenen Messgrößen jeweils Messwerte erzeugt und/oder ein Kalibriersystem und ein Prüfmittel umfasst sein, bei dem Messgrößen jeweils von dem Prüfgegenstand zu dem definierten Prüfmittel übertragen werden, wobei das Prüfmittel in Antwort auf die übertragenen Messgrößen jeweils Messwerte erzeugt.

Bei dem erfindungsgemäßen Prüfmittel zur Verwendung mit einem erfindungsgemäßem Kalibriersystem können die Vorgaben des Kalibriersystems,
-- Prüfmittelvorgaben umfassen, welche von dem Prüfmittel bereitgestellt werden, wobei die Prüfmittelvorgaben eine Eignung des Prüfmittels bezüglich des jeweiligen Kalibrierwertes und/oder einer Messunsicherheit und/oder eines Standortes zur Durchführung des Kalibrierverfahrens bereitstellen; sowie
-- eine Auswahl an für die Bereitstellung der angegebenen Messgröße geeigneten Prüfmitteln;
-- eine Entscheidungsregel zur Konformitätsprüfung;
-- ein Verfahren zur Risikobewertung von Messwerten bezüglich der jeweiligen Messunsicherheit.

Bei dem erfindungsgemäßen Prüfmittel zur Verwendung mit einem erfindungsgemäßen Kalibriersystem kann das Kalibriersystem eine Methode zur Messunsicherheitsberechnung bereitstellen, wobei mittels des Kalibriersystems
- Messunsicherheiten für die erfassten Messwerte unter Verwendung des angegebenen Verfahrens zur Messunsicherheitsberechnung jeweils ermittelt werden,
- ein Risiko für die erfassten Messwerte jeweils ermittelt wird,
   und
- die jeweils ermittelten Messunsicherheiten und/oder des jeweils ermittelten Risikos gemäß gewählter Übereinstimmungskriterien bewertet werden.

Bei dem erfindungsgemäßen Prüfmittel zur Verwendung mit einem erfindungsgemäßen Kalibriersystem können mittels des Kalibriersystems
- Messunsicherheiten für die erfassten Messwerte unter Berücksichtigung von Prüfmittel, Messbereich, und/oder Kalibrierverfahren, und/oder Kalibrierbedingungen und/oder Standort und/oder Standort-/Umgebungsbedingungen und/oder Ablesbarkeit und/oder Mehrfachmessungen und/oder Eigenschaften des Prüfgegenstandes jeweils ermittelt werden.

Weiterhin kann bei dem erfindungsgemäßen Prüfmittel zur Verwendung mit einem erfindungsgemäßen Kalibriersystem das Kalibriersystem eine Methode zur Berechnung für korrigierte bereitgestellte und/oder korrigierte erfasste Messwerte umfassen.

Ferner können, mittles des Kalibriersystems
- Korrekturwerte für korrigierte bereitgestellte und/oder korrigierte erfasste Messwerte unter Berücksichtigung von Prüfmittel, Messbereich, und/oder Kalibrierverfahren, und/oder Kalibrierbedingungen und/oder Standort und/oder Standort-/Umgebungsbedingungen und/oder Ablesbarkeit und/oder Mehrfachmessungen und/oder Eigenschaften des Prüfgegenstandes jeweils ermittelt werden;
- ein Risiko für die erfassten Messwerte jeweils ermittelt werden,
- die korrigierten bereitgestellten und/oder korrigierten erfassten Messwerte und/oder das jeweils ermittelte Risiko gemäß gewählter Übereinstimmungskriterien bewertet werden.

Bei dem erfindungsgemäßen Prüfmittel zur Verwendung mit einem erfindungsgemäßen Kalibriersystem kann dem Kalibriersystem
- wenigstens eine frühere Kalibrierung des zugeordneten Prüfgegenstandes vorliegen, und
- bei Verwendung einer solchen früheren Kalibrierung durch Vergleich mit einer aktuellen Kalibrierung des zugeordneten Prüfgegenstandes ein Driftbericht erstellt werden.

Bei dem erfindungsgemäßen Prüfmittel zur Verwendung mit einem erfindungsgemäßen Kalibriersystem kann das Kalibriersystem für jeden Messwert eine Lageberechnung, Risikoermittlung, Risikobewertung und Konformitätsprüfung nach dessen Erfassung durchführen, bevor ein weiterer Messwert erfasst wird.

Bei dem erfindungsgemäßen Prüfmittel zur Verwendung mit einem erfindungsgemäßen Kalibriersystem kann
- das Kalibriersystem ferner folgendes angeben:
   -- wenigstens ein Hilfsmittel zur Durchführung des Kalibrierverfahrens,
   -- wenigstens eine Umgebungsbedingung für die Durchführung des Kalibrierverfahrens,
   -- einen Standort zur Durchführung des Kalibrierverfahrens,
   -- wenigstens eine Messunsicherheit,
   -- wenigstens ein für die Bereitstellung der angegebenen Messgröße geeigneten Prüfmittel,
   -- Vollständigkeit von Übersetzungen,
   -- Befugnisse der für die Durchführung der Freigabe verantwortlichen Personen,
   -- Veränderungen der Messreihe bei Vorliegen eines noch nicht freigegebenen Ergebnisberichtes,
   -- Vollständigkeit von Vorgaben aus dem Kalibriermaster,
   -- Bewertung gemäß gewählter Übereinstimmungskriterien,
   wobei
   die Konformitätsprüfung und/oder die Plausibilitätsprüfung und/oder die Konformitätsbewertung unter Berücksichtigung wenigstens einer der obigen Angaben durchgeführt werden.

Ferner ist ein erfindungsgemäßes Kalibriersystem zur Verwendung mit einem erfindungsgemäßen Prüfmittel zur Kalibrierung eines Prüfgegenstandes beschrieben, wobei mittels des Kalibriersystems:
- eine Mehrzahl von Kalibriermastern bereitstellt werden, wobei ein Kalibriermaster folgendes angibt:
   -- einen zugeordneten Prüfgegenstand,
   -- ein für den zugeordneten Prüfgegenstand vorgesehenes Kalibrierverfahren mit wenigstens einem Kalibrierwert,
   -- eine Messgröße für den zugeordneten Prüfgegenstand,
- ein Kalibriermaster gewählt wird, dem der Prüfgegenstand zugeordnet ist,
- Vorgaben für die Kalibrierung des Prüfgegenstandes gewählt werden, wobei die Vorgaben umfassen:
   -- ein Verfahren zur Lageberechnung von Messwerten der Messgröße bezüglich des jeweiligen Kalibrierwertes und/oder eine Messunsicherheit;
   -- eine dem Kalibrierwert zugeordnete Spezifikation, wobei die Spezifikation bezüglich des Prüfgegenstands festgelegt wird;
- ein für die angegebene Messgröße geeignetes Prüfmittel definiert wird;
   wobei das definierte Prüfmittel
   Messgrößen für jeden Kalibrierwert erzeugt und
   die Messgrößen jeweils von dem Prüfmittel zu dem Prüfgegenstand übertragen werden, wobei der Prüfgegenstand in Antwort auf die übertragenen Messgrößen jeweils Messwerte erzeugt,
- die jeweils erzeugten Messwerte erfasst werden,
- die Lage der erfassten Messwerte in Bezug zur festgelegten Spezifikation unter Verwendung des Verfahrens zur Lageberechnung jeweils ermittelt wird, um zu prüfen, ob der jeweilige Messwert innerhalb der festgelegten Spezifikation liegt, wobei für jeden Messwert die Lageberechnung nach dessen Erfassung durchgeführt wird,
- Konformitätsprüfungen für jeden der erfassten Messwerte durchgeführt werden,
- auf der Grundlage der durchgeführten Konformitätsprüfungen ermittelt wird, ob die Konformitätsbewertung der Kalibrierung des Prüfgegenstandes erfolgreich war oder nicht,
- eine Plausibilitätsprüfung durchgeführt wird, um zu prüfen, ob die Kalibrierung des Prüfgegenstandes nicht-veränderbar freigegeben werden kann oder nicht.

Ferner ist ein erfindungsgemäßes Kalibriersystem zur Verwendung mit einem erfindungsgemäßen Prüfmittel zur Kalibrierung eines Prüfgegenstandes beschrieben, wobei wobei mittels des Kalibriersystems:
- eine Mehrzahl von Kalibriermastern bereitstellt werden, wobei ein Kalibriermaster folgendes angibt:
   -- einen zugeordneten Prüfgegenstand,
   -- ein für den zugeordneten Prüfgegenstand vorgesehenes Kalibrierverfahren mit wenigstens einem Kalibrierwert,
   -- eine Messgröße für den zugeordneten Prüfgegenstand,
- ein Kalibriermaster gewählt wird, dem der Prüfgegenstand zugeordnet ist,
- Vorgaben für die Kalibrierung des Prüfgegenstandes gewählt werden, wobei die Vorgaben umfassen:
   -- ein Verfahren zur Lageberechnung von Messwerten der Messgröße bezüglich des jeweiligen Kalibrierwertes und/oder eine Messunsicherheit;
   -- eine dem Kalibrierwert zugeordnete Spezifikation, wobei die Spezifikation bezüglich des Prüfgegenstands festgelegt wird;
- ein für die angegebene Messgröße geeignetes Prüfmittel definiert wird;
   wobei der Prüfgegenstand
   Messgrößen für jeden Kalibrierwert erzeugt und
   die Messgrößen jeweils von dem Prüfgegenstand zu dem definierten Prüfmittel übertragen werden, wobei das Prüfmittel in Antwort auf die übertragenen Messgrößen jeweils Messwerte erzeugt,
- die jeweils erzeugten Messwerte erfasst werden,
- die Lage der erfassten Messwerte in Bezug zur festgelegten Spezifikation unter Verwendung des Verfahrens zur Lageberechnung jeweils ermittelt wird, um zu prüfen, ob der jeweilige Messwert innerhalb der festgelegten Spezifikation liegt, wobei für jeden Messwert die Lageberechnung nach dessen Erfassung durchgeführt wird,
- Konformitätsprüfungen für jeden der erfassten Messwerte durchgeführt werden,
- auf der Grundlage der durchgeführten Konformitätsprüfungen ermittelt wird, ob die Konformitätsbewertung der Kalibrierung des Prüfgegenstandes erfolgreich war oder nicht,
- eine Plausibilitätsprüfung durchgeführt wird, um zu prüfen, ob die Kalibrierung des Prüfgegenstandes nicht-veränderbar freigegeben werden kann oder nicht.

Bei dem erfindungsgemäßes Kalibriersystem zur Verwendung mit einem erfindungsgemäßen Prüfmittel kann weiterhin zur Kalibrierung eines Prüfgegenstandes ein Kalibriersystem und ein Prüfmittel umfasst sein, bei dem Messgrößen jeweils von dem Prüfmittel zu dem Prüfgegenstand übertragen werden, wobei der Prüfgegenstand in Antwort auf die übertragenen Messgrößen jeweils Messwerte erzeugt und/oder ein Kalibriersystem und ein Prüfmittel umfasst sein, bei dem Messgrößen jeweils von dem Prüfgegenstand zu dem definierten Prüfmittel übertragen werden, wobei das Prüfmittel in Antwort auf die übertragenen Messgrößen jeweils Messwerte erzeugt.

Bei dem erfindungsgemäßes Kalibriersystem zur Verwendung mit einem erfindungsgemäßen Prüfmittel können die Vorgaben des Kalibriersystems,
-- Prüfmittelvorgaben umfassen, welche von dem Prüfmittel bereitgestellt werden, wobei die Prüfmittelvorgaben eine Eignung des Prüfmittels bezüglich des jeweiligen Kalibrierwertes und/oder einer Messunsicherheit und/oder eines Standortes zur Durchführung des Kalibrierverfahrens bereitstellen; sowie
-- eine Auswahl an für die Bereitstellung der angegebenen Messgröße geeigneten Prüfmitteln;
-- eine Entscheidungsregel zur Konformitätsprüfung;
-- ein Verfahren zur Risikobewertung von Messwerten bezüglich der jeweiligen Messunsicherheit.

Bei dem erfindungsgemäßes Kalibriersystem zur Verwendung mit einem erfindungsgemäßen Prüfmittel kann das Kalibriersystem eine Methode zur Messunsicherheitsberechnung bereitstellen, wobei mittels des Kalibriersystems
- Messunsicherheiten für die erfassten Messwerte unter Verwendung des angegebenen Verfahrens zur Messunsicherheitsberechnung jeweils ermittelt werden,
- ein Risiko für die erfassten Messwerte jeweils ermittelt wird, und
- die jeweils ermittelten Messunsicherheiten und/oder des jeweils ermittelten Risikos gemäß gewählter Übereinstimmungskriterien bewertet werden.

Bei dem erfindungsgemäßes Kalibriersystem zur Verwendung mit einem erfindungsgemäßen Prüfmittel können mittels des Kalibriersystems
- Messunsicherheiten für die erfassten Messwerte unter Berücksichtigung von Prüfmittel, Messbereich, und/oder Kalibrierverfahren, und/oder Kalibrierbedingungen und/oder Standort und/oder Standort-/Umgebungsbedingungen und/oder Ablesbarkeit und/oder Mehrfachmessungen und/oder Eigenschaften des Prüfgegenstandes jeweils ermittelt werden.

Weiterhin kann bei dem erfindungsgemäßes Kalibriersystem zur Verwendung mit einem erfindungsgemäßen Prüfmittel das Kalibriersystem eine Methode zur Berechnung für korrigierte bereitgestellte und/oder korrigierte erfasste Messwerte umfassen.

Ferner können, mittles des Kalibriersystems
- Korrekturwerte für korrigierte bereitgestellte und/oder korrigierte erfasste Messwerte unter Berücksichtigung von Prüfmittel, Messbereich, und/oder Kalibrierverfahren, und/oder Kalibrierbedingungen und/oder Standort und/oder Standort-/Umgebungsbedingungen und/oder Ablesbarkeit und/oder Mehrfachmessungen und/oder Eigenschaften des Prüfgegenstandes jeweils ermittelt werden;
- ein Risiko für die erfassten Messwerte jeweils ermittelt werden,
- die korrigierten bereitgestellten und/oder korrigierten erfassten Messwerte und/oder das jeweils ermittelte Risiko gemäß gewählter Übereinstimmungskriterien bewertet werden. Bei dem erfindungsgemäßes Kalibriersystem zur Verwendung mit einem erfindungsgemäßen Prüfmittel kann dem Kalibriersystem
- wenigstens eine frühere Kalibrierung des zugeordneten Prüfgegenstandes vorliegen, und
- bei Verwendung einer solchen früheren Kalibrierung durch Vergleich mit einer aktuellen Kalibrierung des zugeordneten Prüfgegenstandes ein Driftbericht erstellt werden.

Bei dem erfindungsgemäßes Kalibriersystem zur Verwendung mit einem erfindungsgemäßen Prüfmittel kann das Kalibriersystem für jeden Messwert eine Lageberechnung, Risikoermittlung, Risikobewertung und Konformitätsprüfung nach dessen Erfassung durchführen, bevor ein weiterer Messwert erfasst wird.

Bei dem erfindungsgemäßes Kalibriersystem zur Verwendung mit einem erfindungsgemäßen Prüfmittel kann
- das Kalibriersystem ferner folgendes angeben:
   -- wenigstens ein Hilfsmittel zur Durchführung des Kalibrierverfahrens,
   -- wenigstens eine Umgebungsbedingung für die Durchführung des Kalibrierverfahrens,
   -- einen Standort zur Durchführung des Kalibrierverfahrens,
   -- wenigstens eine Messunsicherheit,
   -- wenigstens ein für die Bereitstellung der angegebenen Messgröße geeigneten Prüfmittel,
   -- Vollständigkeit von Übersetzungen,
   -- Befugnisse der für die Durchführung der Freigabe verantwortlichen Personen,
   -- Veränderungen der Messreihe bei Vorliegen eines noch nicht freigegebenen Ergebnisberichtes,
   -- Vollständigkeit von Vorgaben aus dem Kalibriermaster,
   -- Bewertung gemäß gewählter Übereinstimmungskriterien,
   wobei
   die Konformitätsprüfung und/oder die Plausibilitätsprüfung und/oder die Konformitätsbewertung unter Berücksichtigung wenigstens einer der obigen Angaben durchgeführt werden.

Anzumerken ist, dass sich Prüfgegenstand, Prüfmittel und Kalibriersystem nicht zwangsweise an dem gleichen Ort befinden müssen. Vielmehr können Prüfgegenstand, Prüfmittel und Kalibriersystem sich auch (jeweils) an unterschiedlichen Orten befinden, d.h. somit kann auch unabhängig von ihrer Entfernung zueinander eine erfindungsgemäße Kalibrierung durchgeführt werden.

### KURZBESCHREIBUNG DER ZEICHNUNGEN

Ausführungsbeispiele der Erfindung werden nun unter Bezugnahme auf die beigefügten Zeichnungen beschrieben.
Fig. 1 zeigt eine beispielhafte Umgebung in der ein zu kalibrierender Prüfgegenstand unter Verwendung eines erfindungsgemäßen Verfahrens kalibriert wird;
Fig. 2 zeigt ein Fließdiagramm des erfindungsgemäßen Verfahrens in der Richtung A zur Kalibrierung eines Prüfgegenstandes aus Figur 1;
Fig. 3 zeigt eine beispielhafte Umgebung in der ein zu kalibrierender Prüfgegenstand unter Verwendung eines erfindungsgemäßen Verfahrens kalibriert wird;
Fig. 4 zeigt ein Fließdiagramm des erfindungsgemäßen Verfahrens in der Richtung B zur Kalibrierung eines Prüfgegenstandes aus Figur 3.

### BESCHREIBUNG BEVORZUGTER AUSFÜHRUNGSFORMEN

Im Folgenden soll die Erfindung anhand von in den Zeichnungen dargestellten Ausführungsformen näher erläutert werden, wobei in sämtlichen Zeichnungen im Wesentlichen funktionsgleiche Elemente die gleichen Bezugszeichen haben.

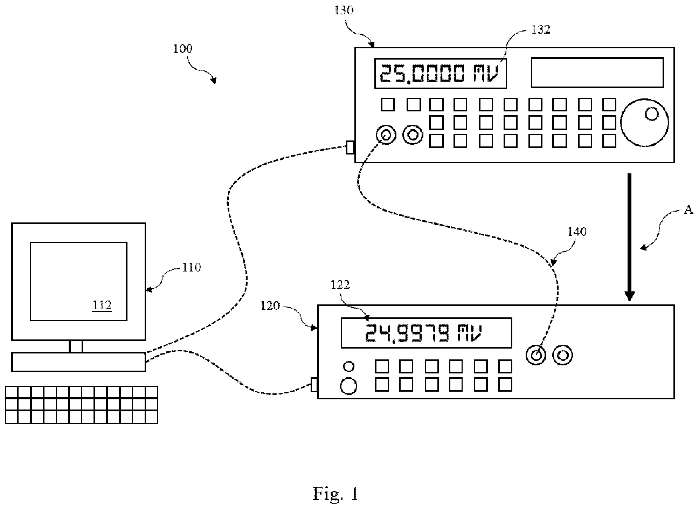

Figur 1 zeigt eine beispielhafte Mess- bzw. Laborumgebung 100, in der ein zu kalibrierender Prüfgegenstand unter Verwendung eines erfindungsgemäßen Verfahrens kalibriert werden kann.

Bei Figur 1 wird das Kalibrierverfahren anhand von elektronischen Geräten, wie Spannungsgerät (Voltmeter), Kabel und Spannungsmessgerät nur beispielshaft veranschaulicht. Figur 1 veranschaulicht beispielhaft die Kalibrierung von Gleichspannungsmessgeräten.

Die vorliegende Erfindung ist allerdings nicht darauf beschränkt, sondern vielmehr können, wie weiter oben beschrieben, eine Vielzahl verschiedener zu kalibrierender Prüfgegenstände, Messgeräte, Maßverkörperungen, Prüfmittel und Hilfsmittel für das Kalibrierverfahren verwendet werden. Die Erfindung ist durch die Ansprüche definiert.

In der beispielhaften Mess- bzw. Laborumgebung 100 befinden sich ein Kalibriersystem 110, ein zu kalibrierender Prüfgegenstand 120 und ein Prüfmittel 130 sowie ein Hilfsmittel 140. Das Prüfmittel 130 ist über ein Hilfsmittel 140, welches als Kabel dargestellt ist, verbunden. Abhängig von den zu kalibrierenden Prüfgegenständen 120 können keine oder aber auch mehrere Hilfsmittel 140 verwendet werden. Die Verwendung eines geeigneten Hilfsmittels 140 richtet sich insbesondere nach Art und Eigenschaften des zu kalibrierenden Prüfgegenstandes. Das Kalibriersystem bzw. Auswertesystem 110 ist in Figur 1 also Computer dargestellt, der eine Mehrzahl von Kalibriermastern 112 bereitstellt und mit dem zu kalibrierenden Prüfgegenstand 120 und dem Prüfmittel 130 verbunden ist. Diese Verbindungen richten sich ebenfalls nach Art und Eigenschaften des zu kalibrierenden Prüfgegenstandes bzw. des verwendeten Prüfmittels, d.h. diese Verbindungen können ebenfalls optional also beispielsweise nicht notwendig sein.

Das Voltmeter von Figur 1 kann dabei für mehrere Bereiche überprüft bzw. kalibriert werden, beispielsweise 100 mV, 0V, 1V, 10V, 100V, 750V, 1000V oder andere (z.B. auch negative) Werte bzw. Wertbereiche.

Bei einem erfindungsgemäßen Verfahren zur Kalibrierung eines Prüfgegenstandes 120 gemäß Figur 1 werden Messgrößen für jeden Kalibrierwert 132 unter Verwendung des definierten Prüfmittels 130 erzeugt. Die Messgröße, bzw. der Kalibrierwert 132, beispielsweise 25,0000 mV, wird anschließend an den Prüfgegenstand 120 übertragen. Dies ist in Figur 1 durch die Richtung A veranschaulicht. In Antwort auf die übertragene Messgröße erfasst und erzeugt der Prüfgegenstand 120 einen Messwert 122, beispielsweise 24,9979 mV. Nach der Übertragung und der Erfassung kann die nächste Messgröße erzeugt und übertragen werden oder wahlweise Korrekturen vorgenommen werden.

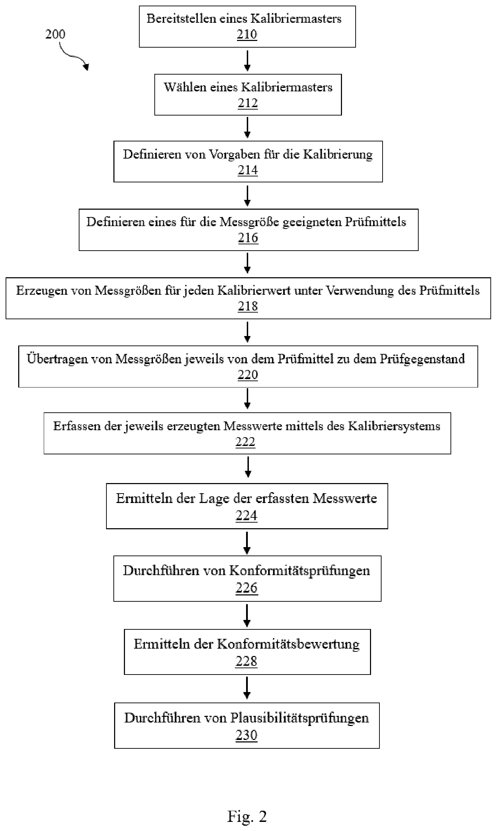

Das durch die Richtung A in Figur 1 veranschaulichte Verfahren zur Kalibrierung eines Prüfgegenstandes wird nun unter Bezug auf Figur 2 beschrieben.

Gemäß Schritt 210 von Figur 2 wird zunächst ein Kalibriermaster 112 von dem Kalibriersystem 110 bereitgestellt, welcher unter anderem einen zugeordneten Prüfgegenstand 120, ein Kalibrierverfahren mit einem Kalibrierwert 132, beispielsweise 25,0000 mV, und eine Messgröße (Zahl und Einheit) angibt.

Gemäß Schritt 212 wird ein geeigneter Kalibriermaster 112 für die Kalibrierung gewählt oder ggf. neu angelegt. Zusätzlich werden in Schritt 214 weitere Vorgaben für die Kalibrierung des Prüfgegenstandes 120 definiert. Diese umfassen beispielsweise ein Verfahren zur Lageberechnung von Messwerten der Messgröße bezüglich des jeweiligen Kalibrierwertes 132 und/oder eine Messunsicherheit sowie eine dem Kalibrierwert 132 zugeordnete Spezifikation, wobei die Spezifikation bezüglich des Prüfgegenstands festgelegt wird und auch durch einen Nullwert festgelegt sein kann, bzw. diesen umfassen kann.

In Schritt 216 wird ein für die angegebene Messgröße geeignetes Prüfmittel 130 definiert, wobei ein (neues) Prüfmittels 130 angelegt werden kann, welches in den Vorgaben bzw. der Auswahl an Prüfmitteln (noch) nicht vorhanden war. Zusätzlich oder alternativ kann auch ein in der Auswahl bzw. den Vorgaben bereits vorhandenes Prüfmittel ausgewählt bzw. festgelegt werden. Insbesondere kann der Kalibriermaster 112 einen Vorschlag für ein geeignetes Prüfmittel 130 bereitstellen oder, für den Fall, dass kein geeignetes Prüfmittel angelegt bzw. vorhanden ist, ein (neues) Prüfmittel angelegt werden.

In Schritt 218 wird eine Messgröße, bzw. ein Kalibrierwert 132, beispielsweise 25,0000 mV, unter Verwendung des Prüfmittels 130 erzeugt und anschließend in Schritt 220 von dem Prüfmittel zu dem Prüfgegenstand 120 übertragen (d.h. in Richtung A).

In Antwort auf die übertragene Messgröße erfasst und erzeugt der Prüfgegenstand 120 einen Messwert 122, beispielsweise 24,9979 mV. Der Messwert 122 sowie der Kalibrierwert 132 werden jeweils in Schritt 222 mittels des Kalibriersystems 110 erfasst und in dem Kalibriermaster 112 aufgezeichnet und hinterlegt.

Für jeden der erfassten Messwerte wird in Schritt 224 die Lage in Bezug zu einer festgelegten Spezifikation, bzw. Toleranz, unter Verwendung eines Verfahrens zur Lageberechnung mittels des Kalibriersystems 110 ermittelt. Es ist jedoch ebenfalls möglich, dass die Spezifikation einen Nullwert umfasst, sodass beispielsweise keine Toleranz für die Kalibrierung vorgegeben sein kann.

Als Toleranz kann beispielsweise ± 0,00475 mV gewählt werden, wodurch sich ein Minimum von 24,99525 mV und ein Maximum von 25,00475 mV ergibt.

Bei der Lageberechnung wird geprüft, ob der jeweilige Messwert 122 innerhalb der festgelegten Spezifikation liegt, wobei für jeden Messwert 122 die Lageberechnung nach dessen Erfassung durchgeführt wird.

Für jeden der erfassten Messwerte 122 werden in Schritt 226 Konformitätsprüfungen durchgeführt und mittels des Kalibriersystems 110 und auf der Grundlage der Konformitätsprüfungen geprüft, ob die Konformitätsbewertung der Kalibrierung des Prüfgegenstandes 120 erfolgreich war oder nicht.

Anschließend werden in Schritt 230 Plausibilitätsprüfungen mittels des Kalibriersystems 110 durchgeführt, um zu prüfen, ob die Kalibrierung des Prüfgegenstandes 120 nicht-veränderbar freigegeben werden kann oder nicht.

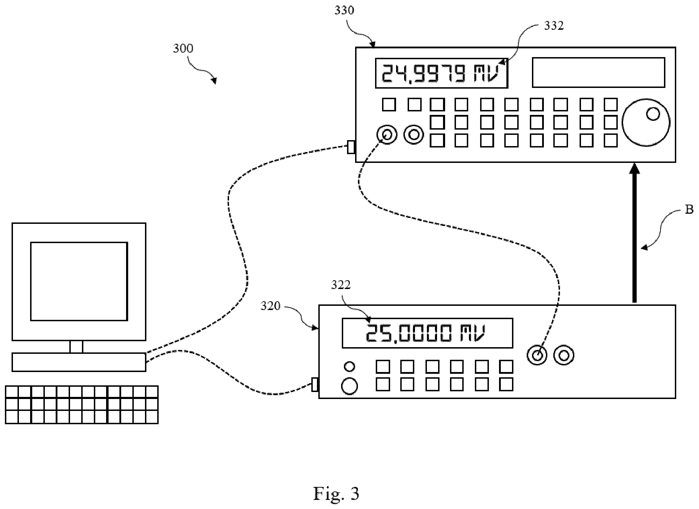

Bei Figur 3 wird das Kalibrierverfahren ebenfalls anhand von elektronischen Geräten, wie Spannungsgerät (Voltmeter), Kabel und Spannungsmessgerät nur beispielshaft veranschaulicht. Figur 3 veranschaulicht beispielhaft die Kalibrierung von Gleichspannungsmessgeräten.

Die Mess-, Labor bzw. Kalibrierumgebung von Figur 3 entspricht im Wesentlichen der Mess, Labor bzw. Kalibrierumgebung von Figur 1.

Im Unterschied zur Figur 1, beschreibt die Figur 3 jedoch ein erfindungsgemäßes Verfahren zur Kalibrierung eines Prüfgegenstandes 320, bei dem Messgrößen für jeden Kalibrierwert 322 unter Verwendung des Prüfgegenstandes 320 erzeugt werden. Die Messgröße, bzw. der Kalibrierwert 322, beispielsweise 25,0000 mV, wird anschließend jeweils von dem Prüfgegenstand 320 zu dem definierten Prüfmittel 330 übertragen. Dies ist in Figur 3 durch die Richtung B veranschaulicht. In Antwort auf die übertragene Messgröße erfasst und erzeugt das definierte Prüfmittel 330 einen Messwert 332, beispielsweise 24,9979 mV. Nach der Übertragung und der Erfassung kann die nächste Messgröße erzeugt und übertragen werden oder wahlweise Korrekturen vorgenommen werden.

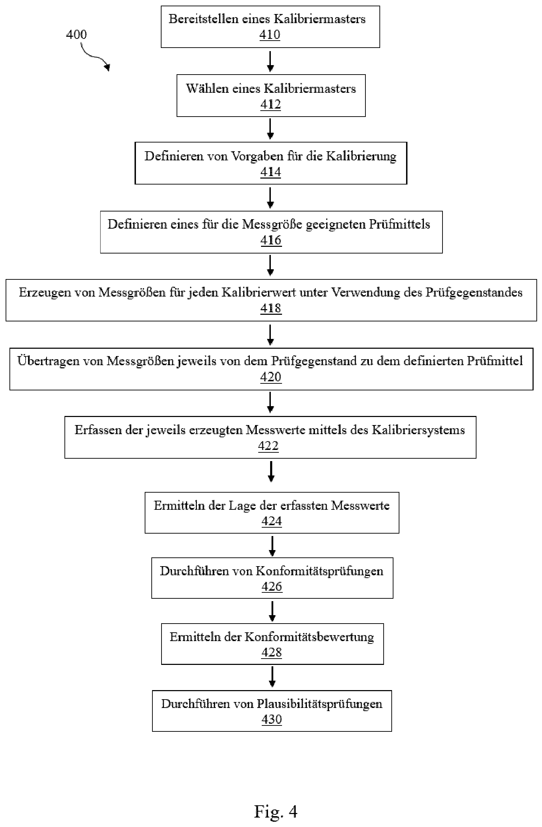

Das durch die Richtung B in Figur 3 veranschaulichte Verfahren zur Kalibrierung eines Prüfgegenstandes wird nun unter Bezug auf Figur 4 beschrieben.

Gemäß Schritt 410 von Figur 2 wird zunächst ein Kalibriermaster 112 von dem Kalibriersystem 110 bereitgestellt, welcher unter anderem einen zugeordneten Prüfgegenstand 320, ein Kalibrierverfahren mit einem Kalibrierwert 322, beispielsweise 25,0000 mV, und eine Messgröße (Zahl und Einheit) angibt.

Gemäß Schritt 412 wird ein geeigneter Kalibriermaster 112 für die Kalibrierung gewählt oder ggf. neu angelegt. Zusätzlich werden in Schritt 414 weitere Vorgaben für die Kalibrierung des Prüfgegenstandes 120 definiert. Diese umfassen beispielsweise ein Verfahren zur Lageberechnung von Messwerten der Messgröße bezüglich des jeweiligen Kalibrierwertes 322 und/oder eine Messunsicherheit sowie eine dem Kalibrierwert 322 zugeordnete Spezifikation, wobei die Spezifikation bezüglich des Prüfgegenstands festgelegt wird und auch durch einen Nullwert festgelegt sein kann.

In Schritt 416 wird ein für die angegebene Messgröße geeignetes Prüfmittel 330 definiert, wobei ein (neues) Prüfmittels 330 angelegt werden kann, welches in den Vorgaben bzw. der Auswahl an Prüfmitteln (noch) nicht vorhanden war. Zusätzlich oder alternativ kann auch ein in der Auswahl bzw. den Vorgaben bereits vorhandenes Prüfmittel ausgewählt bzw. festgelegt werden. Insbesondere kann der Kalibriermaster 112 einen Vorschlag für ein geeignetes Prüfmittel 330 bereitstellen oder, für den Fall dass kein geeignetes Prüfmittel angelegt bzw. vorhanden ist, ein (neues) Prüfmittel angelegt werden.

In Schritt 418 wird eine Messgröße, bzw. ein Kalibrierwert 322, beispielsweise 25,0000 mV, unter Verwendung des Prüfgegenstandes 320 erzeugt und anschließend in Schritt 420 jeweils von dem Prüfgegenstand 320 zu dem definierten Prüfmittel 330 übertragen (d.h. in Richtung B).

In Antwort auf die übertragene Messgröße erfasst und erzeugt das definierte Prüfmittel 330 einen Messwert 332, beispielsweise 24,9979 mV.

Der Messwert 332 sowie der Kalibrierwert 322 werden jeweils in Schritt 422 mittels des Kalibriersystems 110 erfasst und in dem Kalibriermaster 112 aufgezeichnet und hinterlegt.

Für jeden der erfassten Messwerte wird in Schritt 424 die Lage in Bezug zu einer festgelegten Spezifikation, bzw. Toleranz, unter Verwendung eines Verfahrens zur Lageberechnung mittels des Kalibriersystems 110 ermittelt. Es ist jedoch ebenfalls möglich, dass die Spezifikation einen Nullwert umfasst, sodass beispielsweise keine Toleranz für die Kalibrierung vorgegeben sein kann.

Als Toleranz kann beispielsweise ± 0,00475 mV gewählt werden, wodurch sich ein Minimum von 24,99525 mV und ein Maximum von 25,00475 mV ergibt.

Bei der Lageberechnung wird geprüft, ob der jeweilige Messwert 332 innerhalb der festgelegten Spezifikation liegt, wobei für jeden Messwert 332 die Lageberechnung nach dessen Erfassung durchgeführt wird.

Für jeden der erfassten Messwerte 332 werden in Schritt 226 Konformitätsprüfungen durchgeführt und mittels des Kalibriersystems 110 und auf der Grundlage der Konformitätsprüfungen geprüft, ob die Konformitätsbewertung der Kalibrierung des Prüfgegenstandes 320 erfolgreich war oder nicht.

Anschließend werden in Schritt 230 Plausibilitätsprüfungen mittels des Kalibriersystems 110 durchgeführt, um zu prüfen, ob die Kalibrierung des Prüfgegenstandes 320 nicht-veränderbar freigegeben werden kann oder nicht.

Anzumerken ist, dass das in den Figuren 1 und 2 beschriebenen Verfahren und das in den Figuren 3 und 4 beschrieben Verfahren zur Kalibrierung eines Prüfgegenstandes durchgeführt werden können. Mit anderen Worten, das in den Figuren 1 und 2 beschrieben Verfahren und das in den Figuren 3 und 4 beschriebene Verfahren können einzeln und/oder abwechselnd oder zusammen/gemeinsam durchgeführt werden.

Bei den hierin beschriebenen Verfahren können mehrere Messwerte bzw. Messwertreihen jederzeit und erneut, beispielsweise auf Konformität, Lage und Plausibilität überprüft werden. Dies kann beispielsweise nützlich sein, wenn ein Messwert bei der Erfassung offensichtlich fehlerbehaftet ist. In einem solchen Fall kann die Kalibrierung gestoppt/unterbrochen, die Messumgebung erneut auf Fehlerquellen überprüft und anschließend die Kalibrierung fortgesetzt werden. Der fehlerhafte Wert geht damit nicht in die Kalibrierung mit ein. Auf diese Weise werden bei dem erfindungsgemäßen Kalibrierverfahren Fehler bei der Kalibrierung vermeidet. Dies erhöht unter anderem die Genauigkeit der Kalibrierung und verkürzt bzw. vermeidet unnötig lange Kalibrier- bzw. Wartezeiten und führt dadurch zu einer Zeitersparnis. Mit anderen Worten, die Kalibrierung muss nicht notwendigerweise (komplett) abgeschlossen werden, um etwaige Fehlerquellen zu ermitteln und zu minimieren.

Bei den hierin beschriebenen Verfahren werden, im Vergleich zu herkömmlichen Ansätzen, weiterhin verschiedene Abhängigkeiten berücksichtigt. Beispielsweise Abhängigkeiten zwischen Vorlagen, Methoden, Messgrößen, Prüfmitteln, Standorten, Umgebungsbedingungen, Messunsicherheiten, Korrekturwerten oder ähnlichen und/oder anderen hierin beschriebenen Abhängigkeiten.

## Patentansprüche

1. Verfahren (200) zur Kalibrierung eines Prüfgegenstandes (120; 320), mit den Schritten:
- Bereitstellen (210) einer Mehrzahl von Kalibriermastern mittels eines Kalibriersystems, wobei ein Kalibriermaster folgendes angibt:
-- einen zugeordneten Prüfgegenstand (120; 320),
-- ein für den zugeordneten Prüfgegenstand (120; 320) vorgesehenes Kalibrierverfahren mit wenigstens einem Kalibrierwert,
-- eine Messgröße für den zugeordneten Prüfgegenstand (120; 320),
- Wählen (212) eines Kalibriermasters, dem der Prüfgegenstand (120; 320) zugeordnet ist,
- Definieren von Vorgaben für die Kalibrierung des Prüfgegenstandes (120; 320), wobei die Vorgaben umfassen:
-- ein Verfahren zur Lageberechnung von Messwerten der Messgröße bezüglich des jeweiligen Kalibrierwertes und/oder eine Messunsicherheit;
-- eine dem Kalibrierwert zugeordnete Spezifikation, wobei die Spezifikation bezüglich des Prüfgegenstands (120; 320) festgelegt wird;
- Definieren (216) eines für die angegebene Messgröße geeigneten Prüfmittels (130; 330);
wobei das Verfahren ferner die Schritte umfasst:
- Erzeugen (218) von Messgrößen für jeden Kalibrierwert unter Verwendung des definierten Prüfmittels (130; 330) und
- Übertragen (220) der Messgrößen jeweils von dem Prüfmittel (130; 330) zu dem Prüfgegenstand (120; 320), wobei der Prüfgegenstand (120; 320) in Antwort auf die übertragenen Messgrößen jeweils Messwerteerzeugt,
- Erfassen (222) der jeweils erzeugten Messwerte mittels des Kalibriersystems,
- jeweiliges Ermitteln der Lage (224) der erfassten Messwerte in Bezug zur festgelegten Spezifikation unter Verwendung des Verfahrens zur Lageberechnung mittels des Kalibriersystems, um zu prüfen, ob der jeweilige Messwert innerhalb der festgelegten Spezifikation liegt, wobei für jeden Messwert die Lageberechnung nach dessen Erfassung durchgeführt wird,
- Durchführen (226) von Konformitätsprüfungen für jeden der erfassten Messwerte,
- Ermitteln (228) mittels des Kalibriersystems auf der Grundlage der durchgeführten Konformitätsprüfungen, ob die Konformitätsbewertung der Kalibrierung des Prüfgegenstandes (120; 320) erfolgreich war odernicht,
- Durchführen (230) einer Plausibilitätsprüfung mittels des Kalibriersystems für jeden der erfassten Messwerte, um zu prüfen, ob der jeweilige Messwert offensichtlich fehlerbehaftet ist, und zu prüfen, ob die Kalibrierung des Prüfgegenstandes (120; 320) nicht-veränderbarfreigegeben werden kann oder nicht.

2. Verfahren nach Anspruch 1, wobei, wenn die Plausibilitätsprüfung ergibt, dass einer der erfassten Messwerte offensichtlich fehlerbehaftet ist, die Kalibrierung unterbrochen wird, sodass dieser nicht in die Kalibrierung des Prüfgegenstandes (120; 320) mit eingeht.

3. Verfahren (400) zur Kalibrierung eines Prüfgegenstandes (120; 320), mit den Schritten:
- Bereitstellen (410) einer Mehrzahl von Kalibriermastern mittels eines Kalibriersystems, wobei ein Kalibriermaster folgendes angibt:
-- einen zugeordneten Prüfgegenstand (120; 320),
-- ein für den zugeordneten Prüfgegenstand (120; 320) vorgesehenes Kalibrierverfahren mit wenigstens einem Kalibrierwert,
-- eine Messgröße für den zugeordneten Prüfgegenstand (120; 320),
- Wählen (412) eines Kalibriermasters, dem der Prüfgegenstand (120; 320) zugeordnet ist,
- Definieren (414) von Vorgaben für die Kalibrierung des Prüfgegenstandes (120; 320), wobei die Vorgaben umfassen:
-- ein Verfahren zur Lageberechnung von Messwerten der Messgröße bezüglich des jeweiligen Kalibrierwertes und/oder eine Messunsicherheit;
-- eine dem Kalibrierwert zugeordnete Spezifikation, wobei die Spezifikation bezüglich des Prüfgegenstands (120; 320) festgelegt wird;
- Definieren (416) eines für die angegebene Messgröße geeigneten Prüfmittels (130; 330);
wobei das Verfahren ferner die Schritte umfasst:
- Erzeugen (418) von Messgrößen für jeden Kalibrierwert unter Verwendung des Prüfgegenstandes (120; 320) und
- Übertragen (420) der Messgrößen jeweils von dem Prüfgegenstand (120; 320) zu dem definierten Prüfmittel (130; 330), wobei das Prüfmittel (130; 330)in Antwort auf die übertragenen Messgrößen jeweils Messwerteerzeugt,
- Erfassen (422) der jeweils erzeugten Messwerte mittels des Kalibriersystems,
- jeweiliges Ermitteln (424) der Lage der erfassten Messwerte in Bezug zur festgelegten Spezifikation unter Verwendung des Verfahrens zur Lageberechnung mittels des Kalibriersystems, um zu prüfen, ob der jeweilige Messwert innerhalb der festgelegten Spezifikation liegt, wobei für jeden Messwert die Lageberechnung nach dessen Erfassung durchgeführt wird,
- Durchführen (426) von Konformitätsprüfungen für jeden der erfassten Messwerte,
- Ermitteln (428) mittels des Kalibriersystems auf der Grundlage der durchgeführten Konformitätsprüfungen, ob die Konformitätsbewertung der Kalibrierung des Prüfgegenstandes (120; 320) erfolgreich war oder nicht,
- Durchführen (430) einer Plausibilitätsprüfung mittels des Kalibriersystems für jeden der erfassten Messwerte, um zu prüfen, ob der jeweilige Messwert offensichtlich fehlerbehaftet ist, und zu prüfen, ob die Kalibrierung des Prüfgegenstandes (120; 320) nicht-veränderbar freigegeben werden kann oder nicht.

4. Verfahren nach Anspruch 3, wobei, wenn die Plausibilitätsprüfung ergibt, dass einer der erfassten Messwerte offensichtlich fehlerbehaftet ist, die Kalibrierung unterbrochen wird, sodass dieser nicht in die Kalibrierung des Prüfgegenstandes (120; 320) mit eingeht.

5. Kombinationsverfahren, das alle Schritte gemäß Anspruch 1, in der dort angegebenen Reihenfolge, und alle Schritte gemäß Anspruch 3, ebenfalls in der dort angegebenen Reihenfolge, umfasst.

6. Verfahren nach einem der vorherigen Patentansprüche, wobei die Vorgaben ferner
-- Prüfmittelvorgaben umfassen, welche von dem Prüfmittel (130; 330)bereitgestellt werden, wobei die Prüfmittelvorgaben eine Eignung des Prüfmittels (130; 330) bezüglich des jeweiligen Kalibrierwertes und/oder einer Messunsicherheit und/oder eines Standortes zur Durchführung des Kalibrierverfahrens bereitstellen; sowie
-- eine Auswahl an für die Bereitstellung der angegebenen Messgröße geeigneten Prüfmitteln (130; 330);
-- eine Entscheidungsregel zur Konformitätsprüfung;
-- ein Verfahren zur Risikobewertung von Messwerten bezüglich der jeweiligen Messunsicherheit.

7. Verfahren nach einem der vorherigen Patentansprüche, bei dem das Kalibriersystem eine Methode zur Messunsicherheitsberechnung bereitstellt, wobei das Verfahren weiter umfasst:
- jeweiliges Ermitteln von Messunsicherheiten für die erfassten Messwerte unter Verwendung des angegebenen Verfahrens zur Messunsicherheitsberechnung mittels des Kalibriersystems,
- jeweiliges Ermitteln eines Risikos für die erfassten Messwerte mittels des Kalibriersystems,
und
- Bewerten der jeweils ermittelten Messunsicherheiten und/oder des jeweils ermittelten Risikos gemäß gewählter Übereinstimmungskriterien.

8. Verfahren nach einem der vorherigen Patentansprüche, bei dem
- wenigstens eine frühere Kalibrierung des zugeordneten Prüfgegenstandes (120; 320) vorliegt, und
- bei Verwendung einer solchen früheren Kalibrierung durch Vergleich mit einer aktuellen Kalibrierung des zugeordneten Prüfgegenstandes (120; 320) ein Driftbericht erstellt wird.

9. Verfahren nach einem der vorherigen Patentansprüche, bei dem für jeden Messwert eine Lageberechnung, Risikoermittlung, Risikobewertung und Konformitätsprüfung nach dessen Erfassung durchgeführt wird, bevor ein weiterer Messwert erfasst wird.

10. Verfahren nach einem der vorherigen Patentansprüche, bei dem
- das Kalibriersystem ferner folgendes angibt:
-- wenigstens ein Hilfsmittel zur Durchführung des Kalibrierverf ahrens,
-- wenigstens eine Umgebungsbedingung für die Durchführung des Kalibrierverf ahrens,
-- einen Standort zur Durchführung des Kalibrierverfahrens,
-- wenigstens eine Messunsicherheit,
-- wenigstens ein für die Bereitstellung der angegebenen Messgröße geeigneten Prüfmittel (130; 330),
-- Vollständigkeit von Übersetzungen,
-- Befugnisse der für die Durchführung der Freigabe verantwortlichen Personen,
-- Veränderungen der Messreihe bei Vorliegen eines noch nicht freigegebenen Ergebnisberichtes,
-- Vollständigkeit von Vorgaben aus dem Kalibriermaster,
-- Bewertung gemäß gewählter Übereinstimmungskriterien,
wobei
die Konformitätsprüfung und/oder die Plausibilitätsprüfung und/oder die Konformitätsbewertung unter Berücksichtigung wenigstens einer der obigen Angaben durchgeführt werden.

11. Computerprogrammprodukt, umfassend Befehle, die bei der Ausführung des Programms durch einen Computer diesen veranlassen, das Verfahren nach Anspruch 1, 3 und/oder5 auf einem System nach einem der Ansprüche 12, 14 respektive 16 auszuführen.

12. System zur Kalibrierung eines Prüfgegenstandes (120; 320) umfassend:
- ein Prüfmittel (130; 330) und
- ein Kalibriersystem,
wobei mittels des Kalibriersystems:
- eine Mehrzahl von Kalibriermastern bereitstellt werden, wobei ein Kalibriermaster folgendes angibt:
-- einen zugeordneten Prüfgegenstand (120; 320),
-- ein für den zugeordneten Prüfgegenstand (120; 320) vorgesehenes Kalibrierverfahren mit wenigstens einem Kalibrierwert,
-- eine Messgröße für den zugeordneten Prüfgegenstand (120; 320),
- ein Kalibriermaster gewählt wird, dem der Prüfgegenstand (120; 320) zugeordnet ist,
- Vorgaben für die Kalibrierung des Prüfgegenstandes (120; 320) gewählt werden, wobei die Vorgaben umfassen:
-- ein Verfahren zur Lageberechnung von Messwerten der Messgröße bezüglich des jeweiligen Kalibrierwertes und/oder eine Messunsicherheit;
-- eine dem Kalibrierwert zugeordnete Spezifikation, wobei die Spezifikation bezüglich des Prüfgegenstands (120; 320)festgelegt wird;
- ein für die angegebene Messgröße geeignetes Prüfmittel (130; 330) definiert wird; wobei das definierte Prüfmittel (130; 330)
Messgrößen für jeden Kalibrierwert erzeugt und
die Messgrößen jeweils von dem Prüfmittel (130; 330) zu dem Prüfgegenstand (120; 320) übertragen werden, wobei der Prüfgegenstand (120; 320) in Antwort auf die übertragenen Messgrößen jeweils Messwerteerzeugt,
- die jeweils erzeugten Messwerte erfasst werden,
- die Lage der erfassten Messwerte in Bezug zur festgelegten Spezifikation unter Verwendung des Verfahrens zur Lageberechnung jeweils ermittelt wird, um zu prüfen, ob der jeweilige Messwert innerhalb der festgelegten Spezifikation liegt, wobei für jeden Messwert die Lageberechnung nach dessen Erfassung durchgeführt wird,
- Konformitätsprüfungen für jeden der erfassten Messwerte durchgeführt werden,
- auf der Grundlage der durchgeführten Konformitätsprüfungen ermittelt wird, ob die Konformitätsbewertung der Kalibrierung des Prüfgegenstandes (120; 320) erfolgreich war oder nicht,
- eine Plausibilitätsprüfung für jeden der erfassten Messwerte durchgeführt wird, um zu prüfen, ob der jeweilige Messwert offensichtlich fehlerbehaftet ist, und zu prüfen, ob die Kalibrierung des Prüfgegenstandes (120; 320) nicht-veränderbar freigegeben werden kann oder nicht.

13. System nach Anspruch 12, wobei, wenn die Plausibilitätsprüfung ergibt, dass einer der erfassten Messwerte offensichtlich fehlerbehaftet ist, die Kalibrierung unterbrochen wird, sodass dieser nicht in die Kalibrierung des Prüfgegenstandes (120; 320) mit eingeht.

14. System zur Kalibrierung eines Prüfgegenstandes (120; 320) umfassend:
- ein Prüfmittel (130; 330) und
- ein Kalibriersystem,
wobei mittels des Kalibriersystems:
- eine Mehrzahl von Kalibriermastern bereitstellt werden, wobei einKalibriermaster folgendes angibt:
-- einen zugeordneten Prüfgegenstand (120; 320),
-- ein für den zugeordneten Prüfgegenstand (120; 320) vorgesehenes Kalibrierverfahren mit wenigstens einem Kalibrierwert,
-- eine Messgröße für den zugeordneten Prüfgegenstand (120; 320),
- ein Kalibriermaster gewählt wird, dem der Prüfgegenstand (120; 320) zugeordnet ist,
- Vorgaben für die Kalibrierung des Prüfgegenstandes (120; 320) gewählt werden, wobei die Vorgaben umfassen:
-- ein Verfahren zur Lageberechnung von Messwerten der Messgröße bezüglich des jeweiligen Kalibrierwertes und/oder eine Messunsicherheit;
-- eine dem Kalibrierwert zugeordnete Spezifikation, wobei die Spezifikation bezüglich des Prüfgegenstands (120; 320)festgelegt wird;
- ein für die angegebene Messgröße geeignetes Prüfmittel (130; 330) definiert wird; wobei der Prüfgegenstand (120; 320)
Messgrößen für jeden Kalibrierwert erzeugt und
die Messgrößen jeweils von dem Prüfgegenstand (120; 320) zu dem definierten Prüfmittel (130; 330)übertragen werden, wobei das Prüfmittel (130; 330)in Antwort auf die übertragenen Messgrößen jeweils Messwerteerzeugt,
- die jeweils erzeugten Messwerte erfasst werden,
- die Lage der erfassten Messwerte in Bezug zur festgelegten Spezifikation unter Verwendung des Verfahrens zur Lageberechnung jeweils ermittelt wird, um zu prüfen, ob der jeweilige Messwert innerhalb der festgelegten Spezifikation liegt, wobei für jeden Messwert die Lageberechnung nach dessen Erfassung durchgeführt wird,
- Konformitätsprüfungen für jeden der erfassten Messwerte durchgeführt werden,
- auf der Grundlage der durchgeführten Konformitätsprüfungen ermittelt wird, ob die Konformitätsbewertung der Kalibrierung des Prüfgegenstandes (120; 320) erfolgreich war oder nicht,
- eine Plausibilitätsprüfung für jeden der erfassten Messwerte durchgeführt wird, um zu prüfen, ob der jeweilige Messwert offensichtlich fehlerbehaftet ist, und zu prüfen, ob die Kalibrierung des Prüfgegenstandes (120; 320) nicht-veränderbar freigegeben werden kann oder nicht.

15. System nach Anspruch 14, wobei, wenn die Plausibilitätsprüfung ergibt, dass einer der erfassten Messwerte offensichtlich fehlerbehaftet ist, die Kalibrierung unterbrochen wird, sodass dieser nicht in die Kalibrierung des Prüfgegenstandes (120; 320) mit eingeht.

16. Kombinationssystem, das alleMerkmale des Anspruchs 12 und alleMerkmale des Anspruchs 14 umfasst.

## Claims

1. A method (200) for calibrating a test object (120; 320) comprising the steps of:
providing (210) a plurality of calibration masters by means of a calibration system, wherein a calibration master indicates the following:
an associated test object (120; 320);
a calibration method including at least one calibration value, which calibration method is provided for the associated test object (120; 320);
a measured variable for the associated test object (120; 320);
selecting (212) a calibration master that the test object (120; 320) is associated with;
defining standards for the calibration of the test object (120; 320), the standards comprising:
a method for calculating the position of measured values of the measured variable in relation to the respective calibration value and/or a measurement uncertainty;
a specification associated with the calibration value, wherein the specification is determined in relation to the test object (120; 320);
defining (216) testing equipment (130; 330) suitable for the indicated measured variable;
the method further comprising the steps of:
creating (218) measured variables for each calibration value using the defined testing equipment (130; 330); and
transferring (220) each of the measured variables from the testing equipment (130; 330) to the test object (120; 320), wherein the test object (120; 320) creates respective measured values in response to the transferred measured variables;
detecting (222) the respective created measured values by means of the calibration system;
identifying (224), by means of the calibration system, the position of each of the detected measured values in relation to the determined specification using the method for position calculation in order to check whether the respective measured value is within the determined specification, wherein the position is calculated for each measured value after detection thereof;
performing (226) conformity checks for each of the detected measured values;
identifying (228), by means of the calibration system on the basis of the performed conformity checks, whether or not the conformity assessment of the calibration of the test object (120; 320) has been successful;
performing (230), for each of the detected measured values, a plausibility check by means of the calibration system, in order to check whether the respective measured value is obviously faulty, and in order to check whether or not the calibration of the test object (120; 320) can be approved in a non-changeable manner.

2. A method (400) according to claim 1, wherein, in the case the plausibility check results in that a detected measured value of the detected measured values is obviously faulty, the calibration is interrupted so that that detected measured value is not entered into the calibration of the test object (120; 320).

3. A method (400) for calibrating a test object (120; 320) comprising the steps of:
providing (410) a plurality of calibration masters by means of a calibration system, wherein a calibration master indicates the following:
an associated test object (120; 320);
a calibration method including at least one calibration value, which calibration method is provided for the associated test object (120; 320);
a measured variable for the associated test object (120; 320);
selecting (412) a calibration master that the test object (120; 320) is associated with;
defining (414) standards for the calibration of the test object (120; 320), the standards comprising:
a method for calculating the position of measured values of the measured variable in relation to the respective calibration value and/or a measurement uncertainty;
a specification associated with the calibration value, wherein the specification is determined in relation to the test object (120; 320);
defining (416) testing equipment (130; 330) suitable for the indicated measured variable;
the method further comprising the steps of:
creating (418) measured variables for each calibration value using the test object (120; 320); and
transferring (420) each of the measured variables from the test object (120; 320) to the defined testing equipment (130; 330), wherein the testing equipment (130; 330) creates respective measured values in response to the transferred measured variables;
detecting (422) the respective created measured values by means of the calibration system;
identifying (424), by means of the calibration system, the position of each of the detected measured values in relation to the determined specification using the method for position calculation in order to check whether the respective measured value is within the determined specification, wherein the position is calculated for each measured value after detection thereof;
performing (426) conformity checks for each of the detected measured values;
identifying (428), by means of the calibration system on the basis of the performed conformity checks, whether or not the conformity assessment of the calibration of the test object (120; 320) has been successful;
performing (430), for each of the detected measured values, a plausibility check by means of the calibration system, in order to check whether the respective measured value is obviously faulty, and in order to check whether or not the calibration of the test object (120; 320) can be approved in a non-changeable manner.

4. A method (400) according to claim 3, wherein, in the case the plausibility check results in that a detected measured value of the detected measured values is obviously faulty, the calibration is interrupted so that that detected measured value is not entered into the calibration of the test object (120; 320).

5. A combined method comprising all steps according to claim 1 in the order indicated therein and all steps according to claim 3 also in the order indicated therein.

6. The method according to any one of the preceding claims, wherein the standards further comprise:
testing equipment standards provided by the testing equipment (130; 330), wherein the testing equipment standards provide suitability of the testing equipment (130; 330) in relation to the respective calibration value and/or a measurement uncertainty and/or a location for performing the calibration method; and
a selection of testing equipment items (130; 330) suitable for providing the indicated measured variable;
a decision rule for checking conformity;
a method for risk assessment of measured values in relation to the respective measurement uncertainty.

7. The method according to any one of the preceding claims, wherein the calibration system provides a method for measurement uncertainty calculation, the method further comprising:
identifying measurement uncertainties for each of the detected measured values using the indicated method for measurement uncertainty calculation by means of the calibration method;
identifying a risk for each of the detected measured values by means of the calibration system; and
assessing the respective identified measurement uncertainties and/or the respective identified risk according to selected match criteria.

8. The method according to any one of the preceding claims, wherein:
at least one prior calibration of the associated test object (120; 320) is available, and
when using such a prior calibration, a drift report is established by comparison to a current calibration of the associated test object (120; 320).

9. The method according to any one of the preceding claims, wherein, prior to detecting a further measured value, a position calculation, risk identification, risk assessment and conformity check is performed for each measured value after detection thereof.

10. The method according to any one of the preceding claims, wherein the calibration system further indicates the following:
at least one auxiliary means for performing the calibration method,
at least one environmental condition for performing the calibration method,
a location for performing the calibration method,
at least one measurement uncertainty,
at least one testing equipment item (130; 330) suitable for providing the indicated measured variable,
completeness of translations,
authority of persons responsible for conducting approval,
amendments to the test series when a not yet approved result report is present,
completeness of standards from the calibration master,
assessment according to selected match criteria,
wherein the conformity check and/or plausibility check and/or conformity assessment are performed considering at least one of the above items.

11. A computer program product comprising instructions which, when the program is executed by a computer, cause the computer to perform the method according to claims 1, 3 and/or 5 in a system according to claim 12, 14 or 16, respectively.

12. A system for calibrating a test object (120; 320) comprising:
testing equipment (130; 330) and
a calibration system,
wherein, by means of the calibration system:
a plurality of calibration masters is provided, wherein a calibration master indicates the following:
an associated test object (120; 320);
a calibration method including at least one calibration value, which calibration method is provided for the associated test object (120; 320);
a measured variable for the associated test object (120; 320);
a calibration master that the test object (120; 320) is associated with is selected;
standards for the calibration of the test object (120; 320) are selected, the standards comprising:
a method for calculating the position of measured values of the measured variable in relation to the respective calibration value and/or a measurement uncertainty;
a specification associated with the calibration value, wherein the specification is determined in relation to the test object (120; 320);
testing equipment (130; 330) suitable for the indicated measured variable is defined;
wherein the defined testing equipment (130; 330):
creates measured variables for each calibration value; and
each of the measured variables is transferred from the testing equipment (130; 330) to the test object (120; 320), wherein the test object (120; 320) creates respective measured values in response to the transferred measured variables;
the respective created measured values are detected;
the position of each of the detected measured values is identified in relation to the determined specification using the method for position calculation in order to check whether the respective measured value is within the determined specification, wherein the position is calculated for each measured value after detection thereof;
conformity checks are performed for each of the detected measured values;
it is identified, on the basis of the performed conformity checks, whether or not the conformity assessment of the calibration of the test object (120; 320) has been successful;
a plausibility check is performed for each of the detected measured values, in order to check whether the respective measured value is obviously faulty, and in order to check whether or not the calibration of the test object (120; 320) can be approved in a non-changeable manner.

13. System (400) according to claim 12, wherein, in the case the plausibility check results in that a detected measured value of the detected measured values is obviously faulty, the calibration is interrupted so that that detected measured value is not entered into the calibration of the test object (120; 320).

14. A system for calibrating a test object (120; 320) comprising:
testing equipment (130; 330) and
a calibration system,
wherein, by means of the calibration system:
a plurality of calibration masters is provided, wherein a calibration master indicates the following:
an associated test object (120; 320);
a calibration method including at least one calibration value, which calibration method is provided for the associated test object (120; 320);
a measured variable for the associated test object (120; 320);
a calibration master that the test object (120; 320) is associated with is selected;
standards for the calibration of the test object (120; 320) are selected, the standards comprising:
a method for calculating the position of measured values of the measured variable in relation to the respective calibration value and/or a measurement uncertainty;
a specification associated with the calibration value, wherein the specification is determined in relation to the test object (120; 320);
testing equipment (130; 330) suitable for the indicated measured variable is defined;
wherein the test object (120; 320):
creates measured variables for each calibration value; and
each of the measured variables is transferred from the test object (120; 320) to the defined testing equipment (130; 330), wherein the testing equipment (130; 330) creates respective measured values in response to the transferred measured variables;
the respective created measured values are detected;
the position of each of the detected measured values is identified in relation to the determined specification using the method for position calculation in order to check whether the respective measured value is within the determined specification, wherein the position is calculated for each measured value after detection thereof;
conformity checks are performed for each of the detected measured values;
it is identified, on the basis of the performed conformity checks, whether or not the conformity assessment of the calibration of the test object (120; 320) has been successful;
a plausibility check is performed for each of the detected measured values, in order to check whether the respective measured value is obviously faulty, and in order to check whether or not the calibration of the test object (120; 320) can be approved in a non-changeable manner.

15. System (400) according to claim 14, wherein, in the case the plausibility check results in that a detected measured value of the detected measured values is obviously faulty, the calibration is interrupted so that that detected measured value is not entered into the calibration of the test object (120; 320).

16. A combined system comprising all features according to claim 12 and all features according to claim 14.

## Revendications

1. Procédé (200) d'étalonnage d'un objet d'essai (120 ; 320), comprenant les étapes consistant à :
- mettre à disposition (210) une pluralité de modèles d'étalonnage au moyen d'un système d'étalonnage, un modèle d'étalonnage indiquant :
-- un objet d'essai associé (120 ; 320),
-- un procédé d'étalonnage prévu pour l'objet d'essai associé (120 ; 320) avec au moins une valeur d'étalonnage,
-- un mesurande pour l'objet d'essai associé (120 ; 320),
- choisir (212) un modèle d'étalonnage auquel l'objet d'essai (120 ; 320) est associé,
- définir des prédéfinitions pour l'étalonnage de l'objet d'essai (120 ; 320), les prédéfinitions comprenant :
-- un procédé de calcul de position de valeurs de mesure du mesurande relativement à la valeur d'étalonnage respective et/ou une incertitude de mesure ;
-- une spécification associée à la valeur d'étalonnage, la spécification étant définie relativement à l'objet d'essai (120 ; 320) ;
- définir (216) un équipement d'essai (130 ; 330) approprié pour le mesurande indiqué ;
ledit procédé comprenant en outre les étapes consistant à :
- générer (218) des mesurandes pour chaque valeur d'étalonnage en utilisant l'équipement d'essai défini (130 ; 330) et
- transmettre (220) les mesurandes respectifs de l'équipement d'essai (130 ; 330) à l'objet d'essai (120 ; 320), l'objet d'essai (120 ; 320) générant des valeurs de mesure respectives en réponse aux mesurandes transmis,
- acquérir (222) les valeurs de mesure respectives générées au moyen du système d'étalonnage,
- déterminer respectivement la position (224) des valeurs de mesure acquises par rapport à la spécification définie en utilisant le procédé de calcul de position au moyen du système d'étalonnage pour vérifier si la valeur de mesure respective se trouve à l'intérieur de la spécification définie, le calcul de position étant effectué pour chaque valeur de mesure après son acquisition,
- effectuer (226) des contrôles de conformité pour chacune des valeurs de mesure acquises,
- déterminer (228) au moyen du système d'étalonnage, sur la base des contrôles de conformité effectués, si l'évaluation de la conformité de l'étalonnage de l'objet d'essai (120) a été positive ou non,
- effectuer (230), pour chacune des valeurs mesure acquises, un contrôle de plausibilité au moyen du système d'étalonnage pour vérifier si la valeur mesurée respective est manifestement erronée, et pour vérifier si l'étalonnage de l'objet d'essai (120 ; 320) peut être validé de manière non modifiable ou non.

2. Procédé (400) selon la revendication 1, dans lequel, dans le cas où le contrôle de plausibilité aboutit à ce qu'une valeur de mesure acquises parmi les valeurs de mesure acquises est manifestement erronée, l'étalonnage est interrompu de sorte que cette valeur de mesure détectée n'est pas entrée dans l'étalonnage de l'objet de test (120 ; 320).

3. Procédé (400) d'étalonnage d'un objet d'essai (120 ; 320), comprenant les étapes consistant à :
- mettre à disposition (410) une pluralité de modèles d'étalonnage au moyen d'un système d'étalonnage, un modèle d'étalonnage indiquant :
-- un objet d'essai associé (120 ; 320),
-- un procédé d'étalonnage prévu pour l'objet d'essai associé (120 ; 320) avec au moins une valeur d'étalonnage,
-- un mesurande pour l'objet d'essai associé (120 ; 320),
- choisir (412) un modèle d'étalonnage auquel l'objet d'essai (120 ; 320) est associé,
- définir (414) des prédéfinitions pour l'étalonnage de l'objet d'essai (120 ; 320), les prédéfinitions comprenant :
-- un procédé de calcul de position de valeurs de mesure du mesurande relativement à la valeur d'étalonnage respective et/ou une incertitude de mesure ;
-- une spécification associée à la valeur d'étalonnage, la spécification étant définie relativement à l'objet d'essai (120 ; 320) ;
- définir (416) un équipement d'essai (130 ; 330) approprié pour le mesurande indiqué ;
ledit procédé comprenant en outre les étapes consistant à :
- générer (418) des mesurandes pour chaque valeur d'étalonnage en utilisant l'objet d'essai (120 ; 320), et
- transmettre (420) les mesurandes respectifs de l'objet d'essai (120 ; 320) à l'équipement d'essai défini (130 ; 330), l'équipement d'essai (130 ; 330) générant des valeurs de mesure respectives en réponse aux mesurandes transmis,
- acquérir (422) les valeurs de mesure respectives générées au moyen du système d'étalonnage,
- déterminer respectivement (424) la position des valeurs de mesure acquises par rapport à la spécification définie en utilisant le procédé de calcul de position au moyen du système d'étalonnage pour vérifier si la valeur de mesure respective se trouve à l'intérieur de la spécification définie, le calcul de position étant effectué pour chaque valeur de mesure après son acquisition,
- effectuer (426) des contrôles de conformité pour chacune des valeurs de mesure acquises,
- déterminer (428) au moyen du système d'étalonnage, sur la base des contrôles de conformité effectués, si l'évaluation de la conformité de l'étalonnage de l'objet d'essai (120 ; 320) a été positive ou non ;
- effectuer (430), pour chacune des valeurs mesure acquises, un contrôle de plausibilité au moyen du système d'étalonnage pour vérifier si la valeur mesurée respective est manifestement erronée, et pour vérifier si l'étalonnage de l'objet d'essai (120 ; 320) peut être validé de manière non modifiable ou non.

4. Procédé (400) selon la revendication 3, dans lequel, dans le cas où le contrôle de plausibilité aboutit à ce qu'une valeur de mesure acquises parmi les valeurs de mesure acquises est manifestement erronée, l'étalonnage est interrompu de sorte que cette valeur de mesure détectée n'est pas entrée dans l'étalonnage de l'objet de test (120 ; 320).

5. Procédé combiné comprenant toutes les étapes selon la revendication 1, dans l'ordre qui y est indiqué, et toutes les étapes selon la revendication 3, également dans l'ordre qui y est indiqué.

6. Procédé selon l'une des revendications précédentes, dans lequel les prédéfinitions comprennent en outre
-- des prédéfinitions d'équipement d'essai mises à disposition par l'équipement d'essai (130 ; 330), les prédéfinitions d'équipement d'essai mettant à disposition une aptitude de l'équipement d'essai (130 ; 330) relativement à la valeur d'étalonnage respective et/ou une incertitude de mesure et/ou un emplacement pour effectuer le procédé d'étalonnage ; et
-- une sélection d'équipements d'essai (130 ; 330) appropriée pour mettre à disposition le mesurande indiqué ;
-- une règle de décision pour le contrôle de conformité ;
-- un procédé d'évaluation du risque de valeurs de mesure relativement à l'incertitude de mesure respective.

7. Procédé selon l'une des revendications précédentes, dans lequel le système d'étalonnage met à disposition une méthode de calcul d'incertitude de mesure, le procédé comprenant en outre les étapes consistant à :
- déterminer respectivement des incertitudes de mesure pour les valeurs de mesure acquises en utilisant le procédé indiqué de calcul d'incertitude de mesure au moyen du système d'étalonnage,
- déterminer respectivement un risque pour les valeurs de mesure acquises au moyen du système d'étalonnage, et
- évaluer les incertitudes de mesure respectives déterminées et/ou le risque respectif déterminé selon des critères de concordance choisis.

8. Procédé selon l'une des revendications précédentes, dans lequel
- au moins un étalonnage précédent de l'objet d'essai associé (120 ; 320) est disponible, et
- en utilisant un tel étalonnage précédent, un rapport de dérive est généré par comparaison avec un étalonnage actuel de l'objet d'essai associé (120 ; 320).

9. Procédé selon l'une des revendications précédentes, dans lequel, pour chaque valeur de mesure, un calcul de position, une détermination du risque, une évaluation du risque et un contrôle de conformité sont effectués après son acquisition, avant l'acquisition d'une autre valeur de mesure.

10. Procédé selon l'une des revendications précédentes, dans lequel
- le système d'étalonnage indique en outre :
-- au moins une ressource pour effectuer le procédé d'étalonnage,
-- au moins une condition d'environnement pour effectuer le procédé d'étalonnage,
-- un emplacement pour effectuer le procédé d'étalonnage,
-- au moins une incertitude de mesure,
-- au moins un équipement d'essai (130 ; 330) approprié pour mettre à disposition le mesurande indiqué,
-- l'exhaustivité des traductions,
-- les autorisations des personnes chargées d'effectuer la validation,
-- les modifications de la série de mesures en présence d'un rapport de résultats non encore validé,
-- l'exhaustivité des prédéfinitions du modèle d'étalonnage,
-- l'évaluation selon les critères de concordance choisis,
le contrôle de conformité et/ou le contrôle de plausibilité et/ou l'évaluation de la conformité étant effectués en tenant compte d'au moins une des indications ci-dessus.

11. Produit programme d'ordinateur comprenant des instructions qui, lorsque le programme est exécuté par un ordinateur, amènent ce dernier à mettre en œuvre le procédé selon les revendications 1, 3 et/ou 5 sur un système selon les revendications 12, 14 ou 16.

12. Système d'étalonnage d'un objet d'essai (120 ; 320), comprenant :
- un équipement d'essai (130 ; 330) et
- un système d'étalonnage,
dans lequel, au moyen du système d'étalonnage :
- une pluralité de modèles d'étalonnage sont mis à disposition, un modèle d'étalonnage indiquant :
-- un objet d'essai associé (120 ; 320),
-- un procédé d'étalonnage prévu pour l'objet d'essai associé (120 ; 320) avec au moins une valeur d'étalonnage,
-- un mesurande pour l'objet d'essai associé (120 ; 320),
- un modèle d'étalonnage est choisi, auquel l'objet d'essai (120 ; 320) est associé,
- des prédéfinitions pour l'étalonnage de l'objet d'essai (120 ; 320) sont choisies, les prédéfinitions comprenant :
-- un procédé de calcul de position de valeurs de mesure du mesurande relativement à la valeur d'étalonnage respective et/ou une incertitude de mesure ;
-- une spécification associée à la valeur d'étalonnage, la spécification étant définie relativement à l'objet d'essai (120 ; 320) ;
- un équipement d'essai (130 ; 330) approprié pour le mesurande indiqué est défini ;
l'équipement d'essai défini (130 ; 330) générant des mesurandes pour chaque valeur d'étalonnage et
les mesurandes respectifs étant transmis de l'équipement d'essai (130 ; 330) à l'objet d'essai (120 ; 320), l'objet d'essai (120 ; 320) générant des valeurs de mesure respectives en réponse aux mesurandes transmis,
- les valeurs de mesure respectives générées sont acquises,
- la position des valeurs de mesure acquises est déterminée respectivement par rapport à la spécification définie en utilisant le procédé de calcul de position pour vérifier si la valeur de mesure respective se trouve à l'intérieur de la spécification définie, le calcul de position étant effectué pour chaque valeur de mesure après son acquisition,
- des contrôles de conformité sont effectués pour chacune des valeurs de mesure acquises,
- sur la base des contrôles de conformité effectués il est déterminé si l'évaluation de la conformité de l'étalonnage de l'objet d'essai (120 ; 320) a été positive ou non,
- un contrôle de plausibilité est effectué pour chacune des valeurs mesure acquises pour vérifier si la valeur mesurée respective est manifestement erronée et pour vérifier si l'étalonnage de l'objet d'essai (120 ; 320) peut être validé de manière non modifiable ou non.

13. Système selon la revendication 12, dans lequel, dans le cas où le contrôle de plausibilité aboutit à ce qu'une valeur de mesure acquises parmi les valeurs de mesure acquises est manifestement erronée, l'étalonnage est interrompu de sorte que cette valeur de mesure détectée n'est pas entrée dans l'étalonnage de l'objet de test (120 ; 320).

14. Système d'étalonnage d'un objet d'essai (120 ; 320), comprenant :
- un équipement d'essai (130 ; 330) et
- un système d'étalonnage,
dans lequel, au moyen du système d'étalonnage :
- une pluralité de modèles d'étalonnage sont mis à disposition, un modèle d'étalonnage indiquant :
-- un objet d'essai associé (120 ; 320),
-- un procédé d'étalonnage prévu pour l'objet d'essai associé (120 ; 320) avec au moins une valeur d'étalonnage,
-- un mesurande pour l'objet d'essai associé (120 ; 320),
- un modèle d'étalonnage est choisi, auquel l'objet d'essai (120 ; 320) est associé,
- des prédéfinitions pour l'étalonnage de l'objet d'essai (120 ; 320) sont choisies, les prédéfinitions comprenant :
-- un procédé de calcul de position de valeurs de mesure du mesurande relativement à la valeur d'étalonnage respective et/ou une incertitude de mesure ;
-- une spécification associée à la valeur d'étalonnage, la spécification étant définie relativement à l'objet d'essai (120 ; 320) ;
- un équipement d'essai (130 ; 330) approprié pour le mesurande indiqué est défini ;
l'objet d'essai (120 ; 320) générant des mesurandes pour chaque valeur d'étalonnage et
les mesurandes respectifs étant transmis de l'objet d'essai (120 ; 320) à l'équipement d'essai défini (130 ; 330), l'équipement d'essai (130 ; 330) générant des valeurs de mesure respectives en réponse aux mesurandes transmis,
- les valeurs de mesure respectives générées sont acquises,
- la position des valeurs de mesure acquises est déterminée respectivement par rapport à la spécification définie en utilisant le procédé de calcul de position pour vérifier si la valeur de mesure respective se trouve à l'intérieur de la spécification définie, le calcul de position étant effectué pour chaque valeur de mesure après son acquisition,
- des contrôles de conformité sont effectués pour chacune des valeurs de mesure acquises,
- sur la base des contrôles de conformité effectués il est déterminé si l'évaluation de la conformité de l'étalonnage de l'objet d'essai (120 ; 320) a été positive ou non,
- un contrôle de plausibilité est effectué pour chacune des valeurs mesure acquises pour vérifier si la valeur mesurée respective est manifestement erronée et pour vérifier si l'étalonnage de l'objet d'essai (120 ; 320) peut être validé de manière non modifiable ou non.

15. Système selon la revendication 14, dans lequel, dans le cas où le contrôle de plausibilité aboutit à ce qu'une valeur de mesure acquises parmi les valeurs de mesure acquises est manifestement erronée, l'étalonnage est interrompu de sorte que cette valeur de mesure détectée n'est pas entrée dans l'étalonnage de l'objet de test (120 ; 320).

16. Système combiné comprenant toutes les caractéristiques selon la revendication 12 et toutes les caractéristiques selon la revendication 14.
